# EUROPEAN PATENT SPECIFICATION

(11) **EP 3 317 894 B1**
(45) Date of publication and mention of the grant of the patent: **05.08.2020**
(21) Application number: 16734279.9
(22) Date of filing: 28.06.2016
(51) Int. Cl.: H01J 37/32, C23C 16/26, C23C 16/505, C23C 16/54

(54) **DEVICE AND METHOD FOR THE TREATMENT OF A WEB SUBSTRATE IN A PLASMA ENHANCED PROCESS**
VORRICHTUNG UND VERFAHREN ZUR BEHANDLUNG EINES NETZSUBSTRATS IN EINEM PLASMAUNTERSTÜTZTEN VERFAHREN
DISPOSITIF ET PROCÉDÉ POUR LE TRAITEMENT D'UN SUBSTRAT EN BANDE DANS UN TRAITEMENT ASSISTÉ PAR PLASMA

(30) Priority: 03.07.2015 EP 15175312; 29.10.2015 EP 15192213
(43) Date of publication of application: 09.05.2018
(73) Proprietor: Tetra Laval Holdings & Finance S.A., 1009 Pully (CH)
(72) Inventor: FAYET, Pierre, 1006 Lausanne (CH); LARRIEU, Jerome, 1630 Bulle (CH); PILEMALM, Marcus, 23437 Lomma (SE)
(74) Representative: Tetra Pak - Patent Attorneys SE
(86) International application number: PCT/EP2016/065033
(87) International publication number: WO 2017/005554

(56) References cited:
- EP-A1- 1 020 892
- WO-A1-2010/092433
- US-A1- 2008 102 222
- US-A1- 2014 326 182

## Description

The invention lies in the field of plasma enhanced treatment of substrate surfaces. The invention relates to a device and method for continuously treating a web substrate in a plasma enhanced process. The device contains at least one treatment station with a process chamber, wherein at least one plasma treatment unit is allocated to the treatment station which is designed to form a plasma zone within the process chamber for treating a surface of the web substrate. The device further contains a transporting system for continuously transporting the web substrate through the treatment station, with an unwind roller and a rewind roller, wherein the transporting system defines a transporting path of the web substrate through the process chamber.

Web substrates, as e.g. polymer films, are e.g. coated with one or more layers in order to modify specific properties of the web substrate. Web substrates are for example coated with gas, vapour and/or aroma tight barrier layers in order to prohibit the passage of gas, vapour and aroma through the web substrate. Such barrier layers may consist of Silicon oxide or Aluminium oxide.

Gas and aroma tight web substrate are especially suitable for packaging material. Such packaging material finds e.g. application in the field of food and pharmaceutical packaging and is in particular intended to replace aluminium in packaging material.

In other applications coating layers are intended to modify the optical properties of the web substrate.

Generally, the coatings produced in a plasma enhanced process are relatively thin and lie e.g. in the nano-meter range. For this reason the flexible properties of the web substrate remain preserved. Further, the structure of the coating is not adversely affected by the flexible bending of the web substrate.

In a conventional "Chemical Vapour Deposition" (CVD) processes the required process temperatures on the surface to be coated are relatively high. The thermal energy is supplied from the outside. Additional thermal energy may be released by the chemical reaction. High process temperatures, however, may damage the web substrate.

One method for coating web substrates is the so-called "Plasma Enhanced Chemical Vapour Deposition" (PECVD) process. In this chemical process the web substrate is exposed with its surface to be coated to a process gas mixture which contains one or more volatile precursors. A volatile precursor is in particular a precursor gas. The volatile precursors are energized into a plasma generated by a plasma source. As a result, the excited precursors react and/or decompose on the web surface, e.g. to produce a desired deposit/coating. In order to form a silicon oxide layer a precursor can for example be an organosilicon compound.

A Plasma Enhanced Vapour Deposition (PECVD) process utilizes a plasma to enhance chemical reaction rates of the precursors. As a result, PECVD processing allows a treatment, e.g. a deposition/coating, at lower temperatures. As a consequence the thermal stress on the web substrate is reduced.

The lower temperatures in a PECVD process also allow the deposition of organic coatings, such as plasma polymers.

In the PECVD process the thermal energy is released by the acceleration of electrons in the plasma. In addition to the formation of radicals by this process also Ions are formed in the plasma which, together with the radicals, are responsible for the deposition on the web surface. Generally, the gas temperature in the plasma only amounts about a few hundred degrees Celsius. However the temperature at the surface of the web substrate to be coated is much lower.

As a plasma forming method for a plasma CVD apparatus, there is known the so called capacitively coupled plasma (CCP) technology. In the CCP technology, a high frequency voltage is applied to two electrodes opposed to each other thereby forming a plasma between the electrodes.

The patent publication US 7,806,981 discloses a device and method for continuously coating a web substrate in a PECVD process. The device comprises a coating station with a vacuum chamber and within the vacuum chamber a rotating drum which supports and transports the web substrate and which forms a counter-electrode. The device further comprises a plurality of magnetron electrodes on the periphery of the rotating drum, which form the counter-electrode. The magnetron electrodes are facing the web. The device further comprises means for supplying a process gas to the space between the rotating drum and the magnetron electrodes. The magnetron electrodes are powered with an alternating voltage at 40 kHz. The magnetron electrodes produce electromagnetic waves in the microwave range by means of which a plasma is produced between the rotating drum and the magnetron electrodes.

The Magnetron-Technology has numerous limiting factors. A "Magnetron-Drum" arrangement allows only one single coating step. To increase the number of layers and/or the coating thickness on a web substrate several "Magnetron-Drum" arrangements have to be placed in a process line one after another. This, however, is very space consuming.

Furthermore a "Magnetron-Drum" arrangement allows only a coating on one free surface side of the web substrate. The opposite side of the web substrate rests on the rotating drum and thus cannot be coated.

A further drawback is the quality of the coating. If the magnetron electrodes are operated at high power voltages, thicker coatings are achieved with the same process speed. However, as a drawback, the pinhole rate in the coating increases and accordingly the quality of the coating decreases nevertheless.

A further drawback is the process speed which is limited by the design of the device. The process speed can only be increased with a larger drum which allows an increase of the circumferential treatment surface. However, a larger drum diameter is space consuming. Furthermore, as the drum needs to be inside a vacuum chamber, the construction of an installation with a larger drum is more complex and accordingly also expensive.

Further drawbacks are the costs for purchasing, operating and maintaining such a device.

A further known plasma forming method in a plasma CVD apparatus is the so called inductively coupled plasma (ICP) technology. In the ICP technology a high frequency power is supplied to a coil to thereby form an electromagnetic field and thus an induction electric field to generate a plasma. This system does not contain a counter-electrode as it is the case in the CCP technology.

The patent publication US 2008/0102222 A1 discloses an inductive coupling type plasma apparatus for continuously coating a web substrate comprising an (induction) coil to which a high frequency (RF) power is supplied.

The patent publication EP 1 020 892 A1 also discloses an apparatus for the deposition of coatings on a substrate using a magnetically confined planar inductively coupled plasma source. Here as well, the plasma is excited by an (induction) coil to which a high frequency (RF) power is supplied.

In the above mentioned ICP systems the induction coil is under atmospheric condition separated from a vacuum chamber in which the plasma is generated.

Accordingly, a dielectric window has to be provided between the coil and the substrate to be coated. The dielectric window separates the evacuated film formation space from the atmospheric pressure space in an airtight fashion, with the coil being installed in the atmospheric pressure space, but which allows the transmittance of the high frequency electric field into the film formation space.

Furthermore, the above described ICP systems require a faraday shield arranged between the coil and the substrate to be coated in order to screen out the plasma from the capacitive electric field of the coil. I.e. in the above mentioned ICP systems the faraday shield is necessary to obtain an inductive coupled plasma (ICP). The faraday shield decouples the capacitive (CCP) effect from the inductive effect and thus avoids e.g. self bias.

The faraday shield is combined with the dielectric window in order to enable the ignition of an inductively coupled plasma in the process chamber by letting the electromagnetic field from the coil pass through. For igniting the inductive plasma, there is a capacitive field passage needed. At steady state, for maintaining the plasma, only induction is needed. The faraday shield and the dielectric window, are together forming an assembling unit.

The patent publication EP 2 396 804 B1 discloses a device for the large area plasma processing by means of ICP technology as well. However, the antenna concept of the corresponding device substantially differs from the induction coils as mentioned above, so that different effects are achieved than with the conventional ICP technology mentioned above.

The corresponding device, however, is only designed for a surface treatment, in particular coating, of piece goods as e.g. flat panels, solar cells or semiconductor wafer.

It is now an object of present invention to provide a device and method to treat and in particular to coat the surface of a web substrate in a continuous process with high process speed.

Another object of the invention is to provide a device and method to treat and in particular to coat the surface of a web substrate in a continuous process wherein the construction of the treatment station of the device is compact and space saving.

Another object of the invention is to provide a device and method to coat the surface of a web substrate in a continuous process to produce high quality coatings, particularly to produce a uniform surface coating.

Another object of the invention is to provide a device and method to treat and in particular to coat the surface of a web substrate in a continuous process wherein the web substrate can be treated and in particular coated simultaneously or successively on both sides in one process sequence. In one process sequence particularly means in one pass.

Another object of the invention is to provide a device and method to apply a multi-layer coating on the web in a continuous process in one process sequence.

Another object of the invention is to provide a device and method to treat and in particular to coat the surface of a web substrate in a continuous process which allows the arrangement of a plurality of treatment stations along a single process line in a space saving manner.

At least one object is achieved with the device and the method as defined by the claims.

The plasma treatment unit contains at least one extensive antenna and at least one radiofrequency (RF) generator for exciting said extensive antenna to at least one of its resonant frequencies, wherein the transporting system in the process chamber defines a treatment path section for the web substrate, wherein the treatment path section for the web substrate lies opposite to the extensive antenna.

The treatment path section for the web substrate lies in particular spaced from the extensive antenna.

The plasma enhanced process according to present invention is in particular a "Plasma Enhanced Chemical Vapour Deposition" (PECVD) process as described further above.

The Radio Frequency (RF) Generator is in particular a device for supplying continuous or pulsed radio frequency power at one or several frequency to the extensive antenna in order to establish and maintain a plasma zone.

In a preferred embodiment the RF Generator supplies pulsed radio frequency power at one or several frequency to the extensive antenna.

Optionally, a matching network can be provided which interconnects the RF generator and the extensive antenna. Thereby radio frequency reflections at the RF generator output can be avoided and thus an optimal transfer of radio frequency energy from the RF generator to the extensive antenna can be ensured.

An extensive antenna means an antenna with two-dimensional characteristic. I.e., the antenna has a length and breadth which is much larger then its height or thickness, respectively.

In a preferred embodiment of present invention the extensive antenna is a plane antenna. The term "plane" can in particular be understood as a synonym of "planar". The plane antenna is also called flat-bed antenna.

A continuous web substrate treatment in particular means that the web substrate is continuously transported through the plasma zone of the at least one active treatment station.

The plasma zone is formed above the surface of the web substrate to be treated. The plasma zone is in particular planar. The plasma zone is in particular parallel to the extensive antenna.

The length of the plasma zone in process direction and accordingly the length of the treatment path section within the plasma can e.g. be 0.2 to 1 m. A scale up of the length of the plasma zone up to several meters is also possible.

In order to scale up the length of the plasma zone, in particular within a common process chamber, either the length dimension of the antenna is increased or several antennas are provided and arranged side by side to form a continuous plasma zone over its length.

Of course the total length of the plasma zone in the device, and in particular within a common process chamber of the device, can also be increased by providing several plasma treatment units in succession, each forming a plasma zone within the device. In this case the plasma treatment units are separated from each other in process direction and do not form a continuous plasma zone together.

The width of the plasma zone is preferably adjusted to the width of the web substrate to be treated. In order to determine the width of the plasma zone either the width dimension of the extensive antenna is adjusted or several antennas are provided and arranged side by side to form a continuous large area plasma zone over the entire width.

The treatment process can be a surface etching process, a deposition process, i.e. coating process, a surface cleaning process, a surface activation process, a surface modification process or a surface functionalisation process.

The surface modification process and the surface functionalisation processes can be a pre-treatment process for a subsequent coating. The pre-treatment process can in particular be a cleaning of the surface to be coated. The process gas for such a pre-treatment can e.g. be argon nitrogen, oxygen or a mixture of two or more of the listed gases.

However, one treatment process is in particular a coating process. Accordingly, the treatment station is in particular a coating station.

A coating in particular comprises the deposition of an oxide on the surface of the web substrate. The oxide can be SiOₓ (e.g. SiO₂), SiOₓC_{y}H_{z}, AlₓO_{y} (e.g. Al₂O₃) or SiₓN_{y} (e.g. Si₃N₄). A coating can also comprise the deposition of a mixture of two or more of the above mentioned oxides (e.g. SiOₓ / AlₓO_{y}). "X" and "Y" are natural numbers in the range of 1 or higher.

The oxide is or contains in particular silicon oxide using a process gas comprising an organosilicon compound and oxygen. Such an oxide coating forms in particular a barrier layer.

The coating can also comprise or consist of DLC. DLC is a Diamond-Like Carbon which defines a class of amorphous carbon material that displays some of the typical properties of diamond. In this case preferably a hydrocarbon gas, as e.g. acetylene or methane, is used as process gas for producing the plasma.

The coating can have a thickness of 1 to 1000 nm, in particular of 1 to 500 nm.

The plasma treatment unit in particular further contains a separation surface which physically separates the extensive antenna from the environment, in particular from the plasma zone.

The separation surface in particular serves for avoiding a parasitic coating of the extensive antenna, which would be exposed to the plasma zone without separation surface.

The separation surface is in particular parallel to the extensive antenna.

It is possible that the plasma treatment unit forms a separation surface on both sides of the extensive antenna, in case that on both sides of the extensive antenna a plasma zone is formed. I.e. the extensive antenna is sandwiched between a first and second separation surface or plasma zone respectively.

Accordingly, on both sides of the antenna an individual web substrate can be treated. Each web substrate is passing one of the opposed plasma zones.

It is also possible that the same web substrate passes the plasma zones on both sides of the antenna, and accordingly is treated twice. For this purpose the web substrate is deflected along its transporting path by deflection means as e.g. deflection rollers. In dependency of the deflection, the same web surface can be treated twice or both opposite web surfaces can be treated once.

In case of a plane antenna the separation surface is a separation plane.

The separation surface can be formed by a dielectric cover plate. The dielectric cover plate can be part of a plasma source assembly. The cover plate is in particular arranged parallel to the extensive antenna.

The cover plate can be made of glass, a ceramic material or a polymeric material. The cover plate can also be made of a mixed material. The separation surface is in this case arranged between the web substrate, i.e. the treatment path section for the web substrate, and the extensive antenna.

The dielectric cover plate shall e.g. protect the antenna from any interactions with the plasma to avoid contamination and etching of the sensitive electronic parts of the antenna, such as capacitors.

According to another embodiment of the invention the separation surface is formed by the web substrate itself, passing along its treatment path section past the extensive antenna. In the latter case, the plasma zone is formed on the side of the web substrate which is facing away from the extensive antenna.

In this case the web substrate has in particular the same function as the dielectric cover plate described above.

The treatment path section runs in particular parallel to the extensive antenna of the plasma treatment unit. The treatment path section runs in particular parallel to the separation surface of the plasma treatment unit.

In case of a plane antenna the treatment path section is in particular straight. As a result the web substrate running through the treatment path section defines a plane treatment surface. Accordingly, the web section passing through the treatment path section is plane.

According to a first embodiment of the invention the extensive antenna is arranged within the environment of the process chamber.

In this case a dielectric window having a certain strength and accordingly also thickness in order to separate the process chamber from an atmospheric pressure space in an airtight fashion is no longer necessary.

With the ICP system according to present invention no decoupling of an inductive effect from a capacitive effect is necessary. Accordingly, the presence of a faraday shield and a dielectric window separating the antenna from the web substrate to be treated is not necessary with the present invention.

This allows the placement of the antenna within the environment of the process chamber as mentioned above.

Accordingly, a better electrical energy coupling between the inductive system and the plasma without losses in the dielectric window is achieved. As a result, the plasma density and the plasma homogeneity is higher. Hence there is less machine maintenance and higher productivity.

Further, without dielectric window no parasitic coating deposition that contaminates the dielectric window occurs.

If now the coil of the ICP system according to above mentioned state of the art would be placed within the process chamber without dielectric window and faraday shield, the system would produce a capacitive coupled plasma by a high radio frequency (RF) voltage applied to the coil. Accordingly, the plasma would be quite weak. An inductive effect would only be achieved by means of a huge current injected into the coil.

According to a further development of the first embodiment at least two separate plasma zones are arranged within a common process chamber, in particular within a common low pressure environment of the process chamber.

The at least two separate plasma zones can be formed by a common extensive antenna or treatment unit respectively or by at least two individual extensive antennas or treatment units respectively.

In the latter case, the at least two extensive antennas are arranged within the common process chamber, in particular within a common low pressure environment of the process chamber.

Common process chamber means that the low pressure space of the process chamber in which the antennas are arranged is interconnected. Accordingly, the low pressure in the common process chamber is generated by a common pumping system.

In particular, each of the extensive antennas forms a separate plasma zone within the process chamber.

In particular, each of the extensive antenna is powered independently by means of at least one radiofrequency (RF) generator.

The at least two antennas within the common process chamber and accordingly the plasma zones can be arranged in series along the conveying path of the web substrate through the process chamber.

The at least two antennas within the common process chamber and accordingly the plasma zones can be arranged on both sides of the conveying path of the web substrate through the process chamber.

The at least two antennas within the common process chamber and accordingly the plasma zones can be arranged in parallel with respect to the conveying path of the web substrate.

I.e. the at least two antennas within the common process chamber and accordingly the plasma zones are arranged opposite to each other on both sides of the web substrate. Between them the conveying path of the web substrate is arranged. In this case the web substrate separates the two plasma zones from each other.

The at least two antennas within the common process chamber can be designed for successive treating, in particular coating, the same surface of the web substrate. I.e. the treating of the surface is carried out in two or more successive steps in one pass within the common process chamber.

A successive coating can be the formation of one coating layer in two or more steps. The successive coating can be the formation of two or more coating layers above each other (multi-layer deposition).

The at least two antennas within the common process chamber can be designed for simultaneous or successive treating, in particular coating, the two opposite surfaces of the web substrate.

The above disclosed solutions can be combined with each other, of course. I.e. both surfaces of the web substrate can be treated whereas at least one surface is subjected to at least two successive treatment steps in the common process chamber.

The web substrate is guided through the process chamber passing the plasma zones of the antennas within the process chamber.

According to a further development of present embodiment at least two individual web substrates are guided through a common process chamber passing a plasma zone.

In particular, the at least two individual web substrates pass the plasma zone(s) parallel to each other.

The at least to individual web substrates can pass a common plasma zone, which is e.g. enclosed by the at least two individual web substrates.

The at least two individual web substrates can pass separate plasma zones.

The separate plasma zones can be formed by a common antenna, e.g. on both sides of the antenna.

The separate plasma zones can also be formed by individual antennas.

Individual web substrates in particular means that the web substrates are individually unwound from separate rollers.

Individual web substrates in particular means that the web substrates are individual rewound on separate rollers.

According to a second embodiment not being part of the invention the extensive antenna is arranged outside the process chamber.

However, in any case the extensive antenna is designed and arranged such that the plasma zone lies within the process chamber.

In the second embodiment the separation surface can be formed by a dielectric wall section of the process chamber. In this case the extensive antenna and the plasma zone, which is always arranged in the process chamber, are physically separated by the dielectric wall section.

According to a specific embodiment of present invention the plane antenna is vertically aligned.

Accordingly, the treatment path section is in particular aligned vertically. The process direction can be bottom up. The process direction can be top down.

According to another specific embodiment of present invention the plane antenna is horizontally aligned.

Accordingly the treatment path section is in particular aligned horizontally.

According to another specific embodiment of present invention the plane antenna is arranged in an inclined manner.

The treatment process is a roll-to-roll process. The transporting system in particular contains a drive for driving the rewind roller. The starting point of the continuous treatment process is in particular the unwind roller and the end point of the continuous treatment process is in particular the rewind roller.

The transporting system can contain a drive for driving the unwind roller. The transporting system can contain a drive to drive at least one span roller.

According to an embodiment of the invention the transporting system contains a first and a second span member which are spaced from each other. The span members define in between a free span for the web substrate. The free span in particular contains the treatment path section for the web substrate. Such a lay-out allows a free span treatment of the web substrate.

"Free span" in particular means that the treatment path section is defined by the span members, which lie outside the treatment path section and not by a support member supporting the web substrate in the treatment path section.

In this embodiment the plasma zone is located in the area of the free span between the span members.

The span member can be a deflection member, which defines a deflection path for the web substrate. The span members are e.g. rollers, in particular deflection rollers. The web substrate is in particular guided along the circumference of the rollers and thereby deflected.

Span rollers and/or deflection rollers of the transporting system can also be designed for acting as cooling rollers.

The transporting system can contain at least one tensioning member acting on the web substrate for tensioning the web substrate along the treatment path section. The tensioning member can contain a restoring element which generates a restoring force to the tensioning member so that a tension force is exerted on the web substrate.

The transporting system can in particular contain a tension control system with tensioning members for automatically control the tension of the web substrate along its process path.

The span member can be designed as a tensioning member, which exerts a tension force on the free span of the web substrate.

For the sake of completeness, it is mentioned that the span members can also be formed by the unwind and rewind roller which accommodate the web substrate to form coils.

In an embodiment of the invention the treatment path section of the web substrate and thus the web substrate in the process runs at a distance from the separation plane so that the plasma zone is formed between the treatment path section of the web substrate and the separation plane and thus the plasma produced in the plasma zone is confined between the web substrate and the separation plane. Said distance can be e.g. 10 to 100 mm, in particular 30 to 80 mm.

In another embodiment of the invention the treatment path section of the web substrate, and thus the web substrate runs close to the separation surface or forms the separation surface so that the plasma zone is formed on the side of the web substrate which is facing away from the extensive antenna. The distance to the separation surface can be e.g. only 1 mm to 10 mm, in particular 1 mm to 5 mm.

In a further development of said embodiment a first treatment path section of the web substrate runs close to the separation surface or forms the separation surface as described above. Said distance can be e.g. 1 mm to 5 mm. Further, a second treatment path section runs at a distance to the separation surface and the first treatment path section. Said distance can be e.g. 10 to 100 mm, in particular 30 to 80 mm. In this configuration the plasma zone is formed between the first and second treatment path section of the web substrate and thus the plasma produced in the plasma zone is confined between two web substrate sections. Such a configuration avoids parasitic coatings of device parts.

With respect to the process direction, a deflection member can be arranged between the first and second treatment path. The deflection member defines a deflection path for the web substrate. Thus, in the process the web substrate is deflected from the first treatment path section into the second treatment path section or vice versa. Accordingly, the web substrate in the second treatment path section runs in particular in opposite direction to the web substrate in the first treatment path section. The two treatment path sections run in particular parallel to each other.

The plasma treatment unit may contain a bias electrode arrangement with a bias electrode. The bias electrode is made of an electrical conductive material, in particular metal.

The bias electrode is arranged opposite and at a distance to the plane antenna, in particular a plasma source assembly as described further below. The bias electrode is in particular extensive, e.g. plane. The bias electrode can be a flat-bed assembly. The bias electrode runs in particular parallel to the plane antenna.

The bias electrode is powered by an RF generator. Optionally, a matching network can be provided which interconnects the RF generator and the bias electrode. Thereby radio frequency reflections at the RF generator output can be avoided and thus an optimal transfer of radio frequency energy from the RF generator to the bias electrode can be ensured.

The bias electrode can extend over the whole area of the plane antenna. The bias electrode can also extend only over a part of the area of the plane antenna as viewed in process direction.

The web substrate is transported along a treatment path section between the plasma source assembly and the bias electrode.

The treatment station contains a feed passage opening for in particular continuously feeding the web substrate into the process chamber. Further, the treatment station contains a discharge passage opening for, in particular continuously discharging the treated web substrate from the process chamber. The openings are in particular slit-shaped with a large ratio of the depth of the slit to the width of the slit in order to avoid a significant gas flow into the process chamber. This allows the control of a low gas pressure in the process chamber.

The treatment station further contains a gas supply system for supplying a process gas to the plasma zone in the process chamber. The process gas can be fed from the side, e.g. between the separation surface and the web substrate. The feature "process gas" also comprises a process gas mixture.

The gas supply system in particular contains gas injection members for feeding the process gas into the plasma zone. The gas supply system can contain diffuser members for distributing the process gas in the plasma zone.

The process chamber means a chamber where the plasma process takes place and the web substrate is treated, in particular coated.

The process chamber is in particular a low pressure or vacuum chamber, respectively.

The treatment station further contains a pumping system for removing gaseous components from the process chamber.

The pumping system serves in particular for establishing (producing and maintaining) a low pressure (also called under pressure or vacuum) within the process chamber. The term "low pressure" is meant in the comparison to the ambient pressure, in particular to the atmospheric pressure. The low pressure can e.g. amount a few Pascal (Pa), as e.g. 5 Pa. I.e., the process chamber is in particular a vacuum chamber.

The pumping system can also serve to pump volatile by-products produced during the reactions from the process chamber. In this connection the pumping system also has the function of an exhaust system.

The plasma treatment unit according to the first aspect of present invention does not contain a rotating drum anymore. In contrary, the design of the antenna is plane so that the plasma treatment unit can be designed compact and thus place saving. This gives a high flexibility in the design of the device with respect to the treatment of the web substrate. I.e. the device can be designed and configured to suit the needs of the customer.

The device can contain in particular two or more treatment stations.

The two or more treatment stations can form process chambers which are independent from each other with respect to the establishing of a low pressure in the process chamber.

However the process chambers of the two or more treatment station can also be coupled with this respect.

A first treatment station is in particular a pre-treatment station to prepare the surface of the web substrate to a subsequent coating.

According to an embodiment, the device contains at least two treatment stations arranged in series with respect to the process direction for carrying out the same treatment process. As a consequence the plasma zone and hence the treatment area is increased, in particular multiplied, in process direction.

In fact, such a pre-treatment station can be combined with a conventional capacity coupled magnetron device.

According to a specific embodiment, the device contains a first treatment station with at least one plasma treatment unit. In the first treatment station the web substrate surface is e.g. pre-treated for a subsequent coating. However, the first treatment station can also be a first coating.

The device further contains a second treatment station with at least one plasma treatment unit. The second treatment station is e.g. a coating station for coating or further coating the e.g. pre-treated surface of the web substrate, e.g. with a barrier layer. The at least one second treatment station is arranged subsequent to the first treatment station in process direction. The process direction generally corresponds to the transport direction of the web substrate.

In this connection, the device according to the present invention is suitable for a modular layout. The device can e.g. be built from several modules. One or more than one modules contain at least one treatment station according to the invention.

The modules can be combined in a successive arrangement with respect to the process direction.

So, the above mentioned first treatment station can be part of a first module. The above mentioned second treatment station can be part of a second module.

In a further development of the modular concept the device contains a base module. The base module contains a unwind and rewind roller and in particular also the drives to drive the rollers. The base module can be an indispensable component of the modular design.

Further, the base module can also comprise a first treatment station, e.g. for a pre-treatment of a surface of the web substrate to be further treated, e.g. coated. This in the light of the fact, that the web substrate basically has to be pre-treated before applying further treatments as e.g. a coating, on the web substrate.

Further, the device can contain one or more treatment module as described above. The treatment module(s) are arranged subsequent to the base module in process direction.

The modules of the device can be arranged atop each other. This can be the case in particular when the antenna and accordingly the treatment path sections are aligned vertically. If a base module is provided, the base module corresponds to the base of the device.

The device can be terminated at the top by a top module. The top module is in every case arranged above the base module, if provided. The top module is in particular arranged atop a treatment module. The top module in particular contains at least one deflecting member.

Independent of the above described modular concept, the device according to a specific embodiment can contain at least two process sections, wherein to each process section at least one plasma treatment unit for treating the web substrate is allocated. "Process section" means a section in the device where the web substrate is treated. I.e., each process section comprises at least one plasma treatment unit.

The process direction in one process section is bottom up. The process direction in the other process section is top down. I.e., the web substrate is treated in the bottom up process direction of the first process section and in the top down process direction of the second process section as well.

Between the two process sections, at least one deflection member, e.g. a deflection roller, is arranged to deflect the web substrate from the bottom up direction into the top down direction or vice versa.

The at least one deflecting member is in particular arranged above the treatment station(s) or above the treatment modules, respectively.

The at least one deflecting member can be part of a deflecting module. The deflecting module can correspond to the top module as described above.

In an embodiment of the invention on both sides of the treatment path section of the web substrate a plasma treatment unit with a plane antenna is arranged. The plasma treatment units are lying opposite to each other and are spaced from the treatment path section. Between the treatment path section of the web substrate and the plane antenna, in particular the separation plane of the plasma treatment unit, in each case a plasma zone is formed, so that both sides of the web substrate can be treated simultaneously.

Accordingly, the in particular straight path section runs between two plane antennas. The plasma treatment units are in particular placed in a common process chamber of a treatment station.

The plane antennas can be supplied by a common or by separate RF generators.

In an embodiment of the invention the device contains a first treatment station and arranged in processing direction subsequent to the first treatment station a second treatment station. The transporting system is designed such that the web substrate first can be transported through the first treatment station and subsequently through the second treatment station in a continuous manner and in particular in one pass.

The first treatment station can be part of a first treatment module and the second treatment station can be part of a second treatment module. It is also possible that both treatment stations are part of a common treatment module.

The web substrate is in particular transferred between the two treatment stations through feed and discharge passage openings as described above. The feed and discharge passage openings can form process interfaces between modules.

In an embodiment of the invention in processing direction between the plasma treatment unit of a first, preceding treatment station and the plasma treatment unit of a second, subsequent treatment station at least one deflection member is arranged, which deflects the web substrate such that the transporting direction of the web substrate through the plasma zone of the plasma treatment unit of the second treatment station is opposite or in an angle to the transporting direction of the web substrate through the plasma zone of the plasma treatment unit of the first treatment station.

In this case the first and second treatment stations are in particular part of a common treatment module. The two transporting directions can in particular be bottom up and top down as mentioned further above.

The at least one deflection member is in particular arranged outside the process chambers of the preceding and subsequent treatment station. The at least one deflection member can be a deflection roller. The at least one deflection member can be part of a deflection module.

According to another further development of the present invention the extensive antenna as e.g. described above is combined with a rotatable drum.

The rotatable drum is part of the transporting system. The treatment path section of the web substrate is curved and runs along a peripheral surface section of the rotatable drum. This peripheral surface section defines a curved resting surface for the web substrate in the process chamber.

The antenna is in particular integrated in a plasma source assembly as described further below.

In this development the web substrate is treated in a roll-to-roll process as well. I.e. the device contains an unwind roller at the beginning of the process path and a rewind roller at the end of the process path.

Such an arrangement is characterised in that in operation the web substrate, in the region of the formed plasma zone, rests on a curved circumferential treatment surface area of the rotatable drum. The web substrate is in particular transported at the rotation speed of the rotating drum, while being treated, in particular coated.

The plasma zone is arranged in a process chamber, which is in particular a low pressure or vacuum chamber.

According to a first embodiment of this further development the extensive antenna is plane. The plasma source assembly containing the plane antenna is arranged at a distance to the rotatable drum and facing a curved circumferential surface area of the drum so that a gap is formed between the rotatable drum and the plasma source assembly.

The plasma zone is formed in the space formed by the gap. I.e. The plasma zone is formed between the plasma source assembly, in particular the cover plate, and the web substrate resting on the drum. The cover plate facing the drum towards the transporting path of the web substrate is in particular plane as well. The surface of the cover plate forms the separation surface.

According to a second embodiment the extensive antenna is curved. The curved shape of the extensive antenna is in particular adapted to the shape of the curved surface area of a rotatable drum.

Accordingly the cover plate of the plasma source assembly facing the web substrate is in particular curved as well.

The plasma source assembly with its curved antenna is also arranged at a distance to the rotatable drum and facing a curved circumferential surface area of the drum so that a curved gap is formed between the rotatable drum and the plasma source assembly.

The plasma zone is formed in the space formed by the gap. I.e. The plasma zone is formed between the plasma source assembly, in particular the cover plate, and the web substrate resting on the drum. The cover plate facing the drum towards the transporting path of the web substrate is in particular concave. The surface of the cover plate forms the separation surface.

The drum according to the above mentioned embodiments can form a bias electrode as described further above.

According to a third embodiment the extensive antenna is curved as well. The curved shape of the extensive antenna is in particular adapted to the shape of the curved surface area of a rotatable drum. Accordingly the cover plate of the plasma source assembly facing the web substrate is in particular curved as well.

In contrast to the second embodiment the plasma source assembly with its curved antenna is arranged on the rotatable drum. The cover plate facing away from the drum towards the transporting path of the web substrate is in particular convex.

In this case the plasma zone is formed above the surface of the web substrate which is facing away from the drum. The web substrate forms the separation surface.

Generally, one or several of the above described plasma source assemblies can be arranged along the curved circumference of the rotatable drum in process direction in series.

The extensive antenna is the centrepiece of a large-area plasma source. The plane antenna forms a planar plasma source. The curved antenna forms a curved plasma source.

The extensive antenna comprises a plurality of interconnected elementary resonant meshes. Each mesh is composed of inductive and capacitive elements. Each mesh comprises in particular at least two conductive legs and at least two capacitors. This way the antenna has a plurality of resonant frequencies.

For processing larger areas, a plasma treatment unit can comprise at least one supplementary extensive antenna.

The patent publication EP 2 396 804 B1 discloses a technology for generating a plasma by means of exciting a plane antenna of the above mentioned design by a RF generator to at least one of its resonant frequencies.

The patent publication EP 1 627 413 B1 discloses the same technology for generating a plasma, in this case however, by means of exciting a curved antenna by an RF generator to at least one of its resonant frequencies.

Present invention corresponds to a particular application of this technology. For further details regarding the implementation of said technology it is referred to the mentioned patent publications.

The conductive legs can be parallel to each other. I.e. the leg arrangement of the present antenna does not form a coil.

The Radio Frequency (RF) Generator generates high currents in each leg as they are not independent. By this, each mesh generates an electromagnetic field with a more uniform distribution along the longitudinal axis of the mesh.

At resonant frequency there is a standing current wave propagating through the legs producing a standing electromagnetic field in the process chamber which ignites the plasma.

Said resonant frequency can be tuned by an adjustable conductive plate described further below.

The legs are e.g. made of copper, in particular copper tubes. The copper tubes may be cooled by cooling liquid, as e.g. water, to prevent excessive heating of the antenna components such as the capacitors.

As mentioned above, in present invention the copper tubes in particular form the legs of the antenna and not a coil as known from the cited state of the art.

The antenna may contain elementary resonant meshes having two parallel longer conductive legs whose ends are interconnected by transverse shorter connecting elements. Such a design of elementary resonant mesh allows effective interconnections of a plurality of meshes for constituting a large-area antenna.

Elementary resonant meshes, in particular with parallel conductive legs, are in particular interconnected by common legs for forming a ladder shaped resonant antenna. The legs form the ladder spokes. Such a design allows constituting a very large antenna with well defined amplitude distribution of currents over the whole surface of the antenna.

The design of the antenna is in particular such that each resonant frequency corresponds to a sinusoidal current distribution in the antenna legs. This is in particular the case if all capacitors have the same capacitance, and if all the legs are identical (same inductance).

The resonating currents flowing in the antenna legs generate high and uniform electron densities. Accordingly, a plasma is created over a large surface, having good homogeneity within the whole plasma zone, and across the large surface.

In an embodiment of the invention the transport direction of the web substrate is parallel to the conductive legs.

In another embodiment of the invention the transport direction of the web substrate is at an angle, in particular perpendicular, to the conductive legs. In this configuration the plasma treatment of the web substrate surface is more uniform.

According to a first embodiment of the antenna, the transverse shorter connecting elements comprise opposing capacitors.

According to a second embodiment of the antenna, the parallel longer conductive legs comprise opposing capacitors each connected in series between the lengths of a respective conductive leg.

The longer conductive leg comprises at least one capacitor arranged between at least two lengths of a respective conductive leg.

If the legs are formed by copper tubes, then said lengths of the conductive leg are formed by individual copper tubes.

This embodiment in particular applies in cases where the transport direction of the web substrate is perpendicular to the conductive legs.

This embodiment allows the reduction of the RF voltage applied to the antenna.

Both embodiments may be combined, wherein first opposing capacitors are connected within the transverse shorter connecting elements and second opposing capacitors are connected within the conductive legs.

As the extensive antenna has a plurality of interconnected elementary resonant meshes, and as the antenna is excited to at least one of its resonant frequencies, the amplitude distribution of currents in the elementary element meshes of the antenna is stable and can be very well defined over the whole surface of the antenna.

The distribution of current amplitudes can be controlled by choosing which antenna resonant frequency is to be excited by the RF generator.

Resulting from the very well defined current amplitude distribution over the whole surface of the antenna, a very well defined distribution of plasma can be created by the antenna of the invention.

Considering that the plasma quickly diffuses from areas with high current intensities to areas with lower current intensities, a more uniform distribution of plasma can be created by the antenna of the invention.

The presence of the plasma slightly affects the resonant frequencies values, essentially because of inductive couplings.

In order to compensate the frequency shifts, the plasma treatment unit according to the invention can comprise a conductive plate, also called shield. The conductive plate is in particular arranged parallel to the antenna. The conductive plate is in particular arranged close to the antenna. The conductive plate is in particular grounded. The conductive plate is in particular made of metal. The conductive plate is arranged on the side of the antenna which is facing away from the treatment path section of the web substrate, i.e. the plasma zone, and the separation surface respectively.

In an embodiment of the invention the legs, and in particular the copper tubes forming the legs, are embedded in a dielectric material. The dielectric material has in particular a high thermal conductivity in order to remove heat from the legs. Further, the dielectric material in particular gives robustness to the device.

In an embodiment the entire extensive antenna is embedded in a dielectric material.

The dielectric material can be a foam.

The dielectric material can be a silicone elastomer. The dielectric material can be made of silica or alumina.

The plasma treatment unit can in particular comprise a plasma source assembly with an extensive antenna embedded in a dielectric material. The plasma source assembly can be delimited on the side facing the plasma zone by a dielectric cover plate forming the separation surface.

The plasma source assembly, on the opposite side of the cover plate, can be delimited by the conductive plate forming a base plate.

The plasma source assembly, on the connecting sides, can be delimited by a frame structure.

In case of a plane antenna, the plasma source assembly is in particular designed as flat-bed assembly.

Conductive plate and cover plate run in particular parallel to each other. Hence, the extensive antenna embedded in the dielectric material is sandwiched between the cover plate and the base plate.

Means for adjusting the position, in particular the distance of the conductive plate relative to the antenna can be provided, so that the resonant frequencies of the antenna can be (fine) adjusted. The conductive plate is in particular close to the antenna.

By adjusting the relative position of the conductive plate with the antenna, the resonant frequencies of the antenna can be tuned in order to correspond to the RF generator excitation frequencies.

Furthermore, by adjusting the relative position of the conductive plate, the wave's energy deposition pattern in the plasma can be influenced, and this can be used as a means for adjusting the boundaries conditions of the plasma EM normal modes.

However, the conductive plate is not an essential feature of present invention as the resonant frequency can also be configured by choosing different capacitors.

If on both sides of the extensive antenna a separation surface is formed which, in each case, separates the extensive antenna from a plasma zone, the plasma source assembly can contain a second dielectric cover plate instead of a conductive base plate.

However, in such an arrangement the separation surface can also be formed in each case by a treatment path section of a web substrate on both sides of the extensive antenna.

In known inductively coupled plasma sources limitations are met in the attempt of up scaling due to power injection problems (very high current / voltages into the matching elements and the feeding lines).

The resonant antenna according to the invention is in particular characterised by a finite and non-reactive impedance. I.e. the present antenna presents purely real impedance (typically close to 50 Ohm when coupled to the plasma) and thus independently of the antenna size. This enables convenient up-scaling of the plasma source to create a large area plasma zone, e.g. up to meters of length. Thus, the processed surfaces can be greatly extended.

This means that the impedance is purely resistive. This is in contrast to CCP or standard ICP systems which have coils as mentioned in the introduction of the state of the art.

CCP systems for example have an impedance Z=1/A where A is the surface area of the electrode. For large surface area, A is Large and Z is small. Z tends to nil for extremely large surface area. However, if Z is small very large currents are produced.

On the other hand for standard ICP systems with coils known in the state of the art the impedance is Z=N^{∗}R, where N is the number of turns of the coil and R is the finite diameter of the coil. For large surfaces area this leads to very high impedance with low current and very high voltage.

The antenna according to present invention is in particular resonant which means the impedance Z is finite and non reactive. Therefore, one can expect to build an antenna of almost any size up to several square meters.

According to an embodiment, the treatment station according to the invention may further comprise a system for generating a magnetic field, in particular a static magnetic field, in the vicinity of the extensive antenna. With such a magnetic field plane polarized helicon-like waves can be excited in the plasma, so that the processing rate of the apparatus is improved.

The magnetic field can be generated by permanent magnets or by DC (direct current) coils.

According to a further development of this embodiment the device may comprise an array of permanent magnets. The array of magnets is in particular arranged parallel to the extensive antenna. In case of a plane antenna the array of magnets lies in a plane. The magnets are in particular arranged on the side of the web substrate in the treatment path section facing away from the extensive antenna.

For the sake of completeness it is mentioned that the device may further comprise means for injecting a DC (direct current) in said extensive antenna superposed to the radiofrequency current such that said DC generates a magnetic field in the vicinity of the extensive antenna.

The means can comprise a DC generator.

The DC (direct current) is in particular injected into the conductive legs of the antenna. The antenna can be feed with DC (direct current) at the end in particular at both ends of each conductive leg.

The DC (direct current) is in particular fed to the conductive legs through choke coils.

According to an embodiment, the antenna is fed with at least two phase shifted RF power signals at two different, i.e. distant, injection points, resulting in a translation with time of the current distribution in the legs of the antenna. In other words, this results in a travelling current distribution. This proceeding is also called "bi-phased feeding". Accordingly, the radio frequency generator is adapted for feeding the antenna with two phase shifted RF power signals.

Accordingly, the plasma distribution is translated with time over the whole surface of the antenna. This results in a more uniform processing distribution, i.e. plasma heating. Furthermore, the travelling current distribution enhances strongly the helicon-like wave excitation.

The phase shifted signals can be obtained by combining several RF generators. The phase shifted signals can also be obtained by splitting the signal issued from a single generator with a power splitter and a phase shifter.

Helicon wave discharges are known to efficiently produce high-density plasma, and have been exploited as a high density plasma tool for semiconductor processing, as etching, deposition, sputtering.

A helicon wave is a low frequency electromagnetic wave that can exist in plasmas in the presence of a magnetic field.

A helicon discharge is an excitation of plasma by helicon waves induced through radio frequency heating. The difference between a helicon plasma source and a inductively coupled plasma is the presence of a magnetic field directed along the axis of the antenna. The presence of this magnetic field creates a helicon mode of operation with higher ionization efficiency and greater electron density than a typical ICP (Inductively Coupled Plasma).

The web substrate is a flexible material. Flexible means that the web substrate can be bent without suffering a structural damage.

The web substrate can be a single-layered or multi-layered film. A multi-layered film particularly contains a carrier film. The single-layered or multi-layered film particularly contains a polymer material or consists of it. In particular at least one layer of a multi-layered film is a polymer film. In an embodiment the web substrate is a multi-layered film with a carrier film made of a polymer material.

The web substrate, i.e. the polymer film or a layer of the polymer film, e.g. the carrier film, can be of polyester, as e.g. a poly(ethylene terephthalate) (PET), polybutyleneterephthalate (PBT) or polyethylenenaphthenate. The web substrate or film can also be of polyalkene, as e.g. polyethylene (PE), polypropylene (PP) or cyclo-olefine (co)polymer. The web substrate or film can also be of polyamide (PA), ethylvinylalcohol (EVOH) or liquid-crystal polymer (LCP). The web substrate or film can also be of halogenated plastic as e.g. polyvinyl chloride (PVC) or polyvinylidene chloride (PVDC).

The invention also concerns a method for continuously treating a web substrate in a plasma enhanced process with a device as described above. The method contains the steps of:
- providing a web substrate with a first web end section which is placed on an unwind roller and with a second web end section which is placed on a rewind roller and with an intermediate web section;
- generating a plasma in the plasma zone of the plasma treatment unit in the treatment station;
- in particular continuously, unwinding the web substrate from the unwind roller and, in particular continuously, rewinding the web substrate by the rewind roller, thereby
- in particular continuously, transporting an intermediate web section of the web substrate along the treatment path section in the at least one treatment station through the plasma zone of the plasma treatment unit and thereby plasma treating a surface of the web substrate.

The device according to the invention has at least one of the following advantages:
- due to the high uniformity of the generated plasma the treatment a high quality surface treatment and in particular coating is achieved;
- the device enables a continuous treatment of a web substrate particularly without edge effects;
- the device enables a large area treatment of a web substrate;
- the device enables a simultaneously treatment, particularly a coating, on both sides of the web substrate;
- the device enables a multi-layer coating on the web substrate in one process sequence;
- the device enables a sequence of similar or different treatments on the web substrate in one process sequence;
- the device can be designed in a space-saving manner even if several plasma treatment stations for the web substrate are provided within the device;
- the design of the device is simple;
- the invention allows a modular setup of the device. Thus, a single device can be adapted to different needs for web treatment;
- the device can be operated at higher line speed (transportation speed of the web substrate), e.g. at 400 m/min (meter per minute). Due to a place saving arrangement of the plasma treatment stations, the invention allows the arrangement of two, three or even more treatment stations in series carrying out the same treatment process in order to double, triple, etc. the plasma zone in process direction. As a consequence a doubling (800 m/min) or triplication (1'200 m/min), etc. of the transportation speed is achieved;
- due to high density of the generated plasma, the device can be operated at higher deposition rates for barrier coatings. The dynamic growth rate can e.g. be 2 um/min (micrometer per minute);
- the plasma treatment unit does not contain moving parts, as e.g. rotating electrodes;
- the device produces an inductive coupled plasma and does not have to contain an electrode/counter-electrode arrangement as it is the case with a capacitive coupled plasma with magnetron technology. The power is rather inductively coupled to the plasma;
- there is no plasma arcing, which can cause pinholes in the polymer film;
- the web substrate has not to be supported by a support during the treatment;
- the waste of web substrate is reduced as only setup waste accrues but not trimming waste. An edge trimming is not necessary;
- the inductive coupled plasma generation technology according to present invention does not limit the dimension of the plasma zone. I.e. there are no technology-based restrictions with regard to an up-scaling.

Features which are disclosed in connection with a formulation as "in particular" are to be considered as optional features of present invention.

Exemplified embodiments of the device according to the invention are described in connection with the following figures. The figures show schematically:
- Fig. 1a and 1b: a first embodiment of elementary mesh for the plane antenna, and the equivalent electric circuit thereof;
- Fig. 1c: illustrates a high pass antenna with a series of elementary meshes according to the first embodiment;
- Fig. 2a and 2b: a second embodiment of elementary mesh for the plane antenna, and the equivalent electric circuit thereof;
- Fig. 2c: a low pass antenna with a series of elementary meshes according to the second embodiment;
- Figs. 3a and 3b: a third embodiment of elementary mesh for the plane antenna, and the equivalent electric circuit thereof;
- Fig. 3c: a hybrid antenna with elementary meshes according to the third embodiment;
- Fig. 4: a first embodiment of a device according to the invention;
- Fig. 5: a second embodiment of a device according to the invention;
- Fig. 6a: a third embodiment of a device according to the invention;
- Fig. 6b: a cross section of the web substrate treated with the device according to figure 6a;
- Fig. 7a: a fourth embodiment of a device according to the invention;
- Fig. 7b: a cross section of the web substrate treated with the device according to figure 7a;
- Fig. 8: an embodiment of a treatment station according to the invention;
- Fig. 9: a further embodiment of a web run in a treatment station according to the invention;
- Fig. 10: a further embodiment of a web run in a treatment station according to the invention;
- Fig. 11: an embodiment of a plasma source assembly according to the invention;
- Fig. 12: an assembly draft of a specific embodiment of a device according to present invention;
- Fig. 13: a first embodiment of a plasma treatment unit with a rotatable drum;
- Fig. 14: a second embodiment of a plasma treatment unit with a rotatable drum;
- Fig. 15: a further embodiment of a treatment station according to the invention;
- Fig. 16: a further embodiment of a treatment station according to the invention.

According to the invention, a plane antenna with a plurality of elementary resonant meshes is provided as a source for generating large area plasmas.

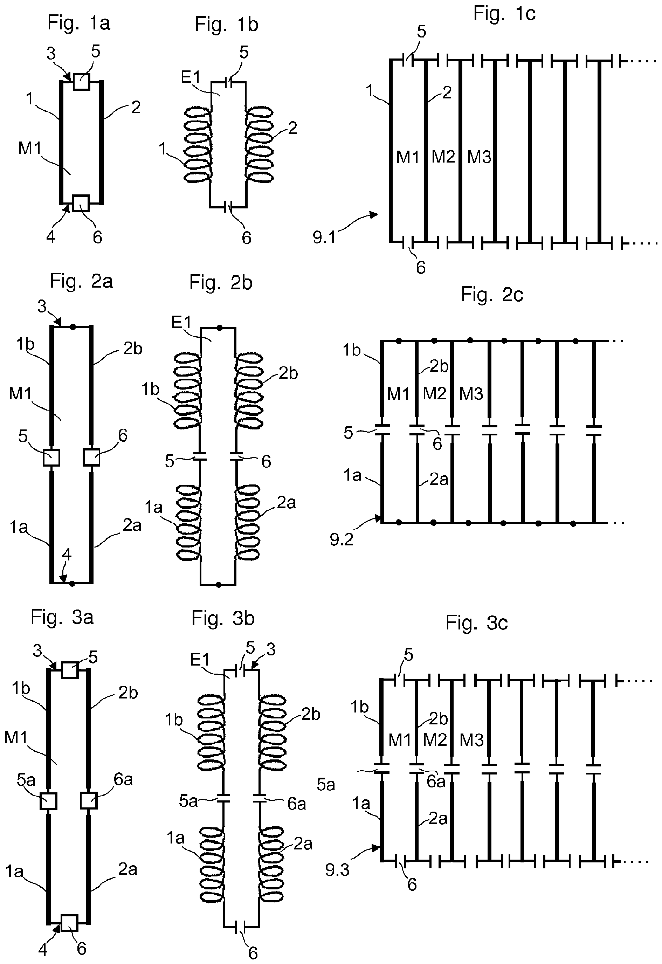

Figures 1, 2 and 3 show three embodiments for such an elementary mesh M1 and the corresponding equivalent electric circuit El.

Each elementary mesh M1 has two parallel longer conductive legs 1 and 2 whose ends are interconnected by transverse shorter connecting elements 3 and 4. The longer connecting legs 1 and 2 act essentially as inductive components. Each elementary mesh has at least two opposing capacitors 5 and 6 (figures 1a, 2a, 3a).

In the high pass mesh of figure 1, the opposing capacitors 5 and 6 constitute said shorter connecting elements 3 and 4.

In the low pass mesh of figure 2, the opposing capacitors 5 and 6 are each connected in series between two lengths la, 1b or 2a, 2b of a respective conductive leg 1 or 2.

In the pass band mesh of figure 3, two first opposing capacitors 5 and 6 constitute said shorter connecting elements 3 and 4, and two second capacitors 5a and 6a are each connected in series between two lengths la, 1b or 2a, 2b of a respective conductive leg 1 or 2.

Each elementary mesh forms a resonant L-C loop as shown on the corresponding equivalent electric circuits El (figures 1b, 2b, 3b).

Several elementary meshes are interconnected in order to form a plane antenna of the desired dimensions.

For instance, figure 1c shows a high pass antenna 9.1 (generally named: 9) made of a series of elementary high pass meshes M1, M2, M3 according to figure 1b, interconnected to form a ladder-shaped resonant antenna.

Figure 2c shows a low pass antenna 9.2 made of a series of low pass meshes M1, M2, M3 according to figure 2b, interconnected to form a ladder-shaped resonant antenna.

Figure 3c shows a hybrid antenna 9.3 made of a series of elementary meshes M1, M2, M3 according to figure 3b, interconnected to form a ladder-shaped resonant antenna.

In all three embodiments, adjacent meshes such as meshes M1 and M2 have a common conductive leg 2.

If N is the number of legs of the antenna, said antenna presents N-1 resonant frequencies.

The values of these resonant frequencies depend on the geometry of the legs 1, 2 (length, diameter, distance between two adjacent legs...) and on the values of the capacitors 5, 6.

The antenna can be operated at e.g. 50 kW and 13.56 MHz.

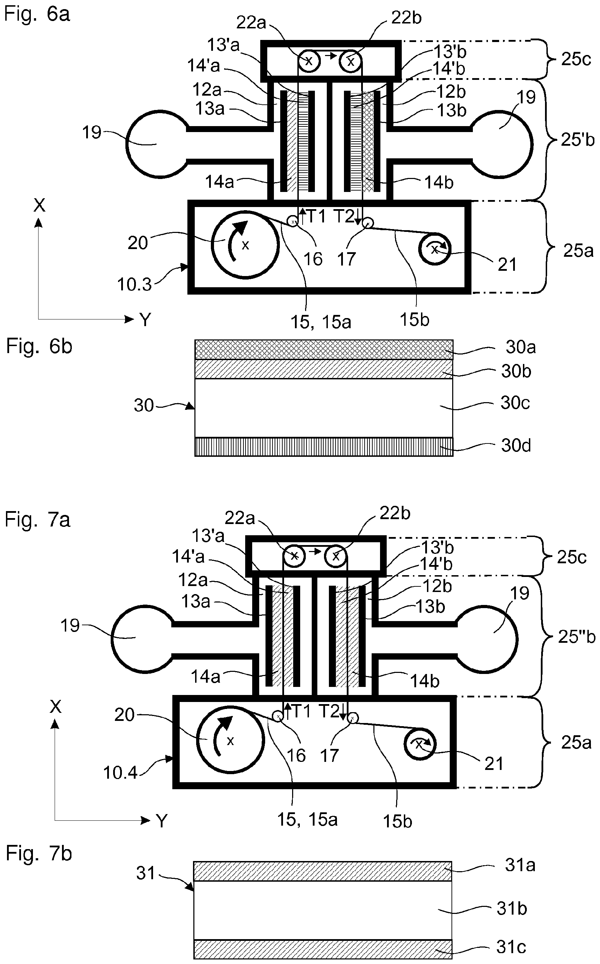

If all capacitors 5, 6 have the same capacitance, and if all the legs 1,2 are identical (same inductance), each resonant frequency corresponds to a sinusoidal current distribution in the antenna legs such as legs 1,2, as shown for instance on figure 7 of EP 2396 804 B1.

When excited at a resonant frequency, the antenna produces an electromagnetic (EM) field pattern with a very well defined sinusoidal spatial structure. This allows a great control on the excitation of EM normal modes in the plasma (normal mode = eigenfunction). The antenna will always be excited (or fed) at one, or several, of its resonant frequencies.

A large variety of EM waves can be excited in plasmas. Certain categories of waves can only exist if the plasma is magnetized, as for example helicon waves.

Helicon waves are interesting because they lead, when damped, to a strong heating of the plasma, and then to high electrons densities. Plane polarized "helicon-like" waves can be excited in a plasma slab, typically in the radiofrequency (RF) range (typ. 1-100 MHz). Hence in a preferred embodiment a static magnetic field is applied in the vicinity of the antenna and the process chamber.

It has to be noticed that this is not a strict requirement for a plasma to be generated by the antenna, as the antenna can also operate without any (static) magnetic field, essentially by means of an inductive coupling with the plasma.

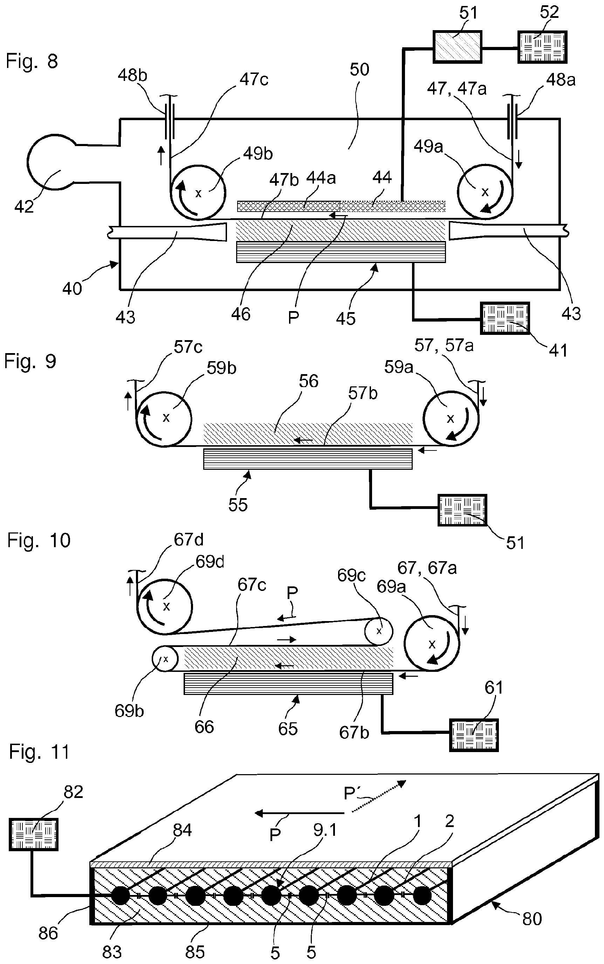

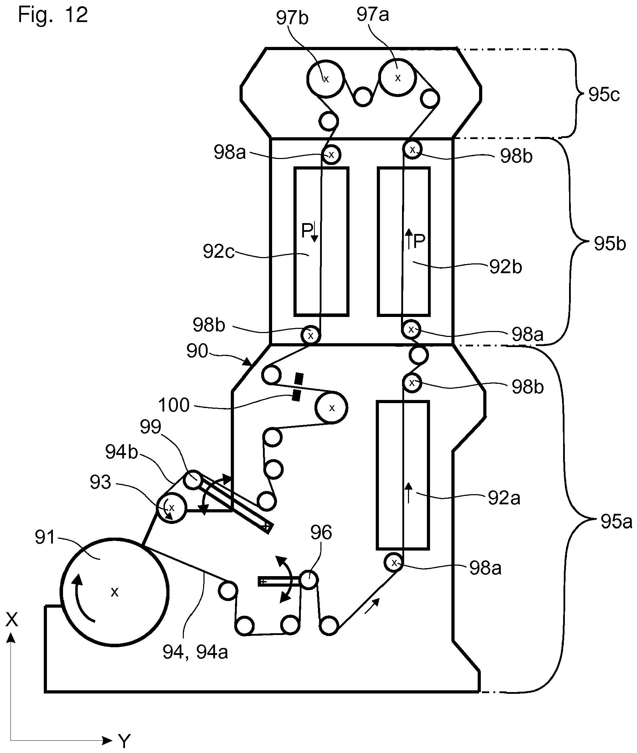

The (static) magnetic field can be generated by different means, such as permanent magnets as shown on figures 11 and 12 of EP 2 396 804 B1, or DC (direct current) injected into the antenna on both ends of the conductive legs in each case through choke coils as shown in figure 18 of EP 2 396 804 B1.

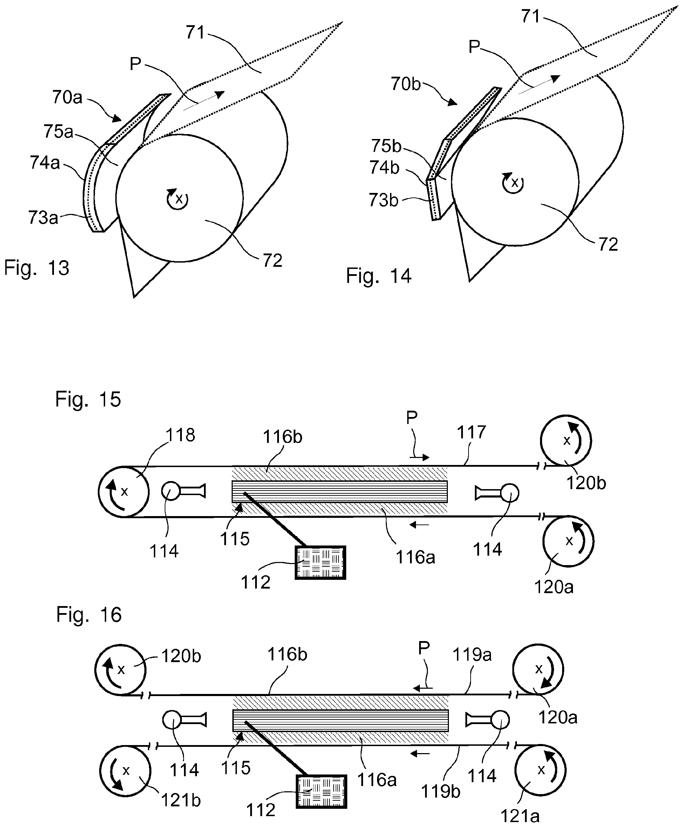

As long as the RF generator frequency corresponds to a desired resonant frequency of the antenna, the RF energy might be injected anywhere on the antenna structure. As a matter of fact, if the antenna is excited at a resonant frequency, the current distribution is not affected by the localization of the RF injection points. But the antenna impedance "seen" by the RF generator will depend on these injection points. From this point of view, it is generally better, although not necessary, to feed the antenna all across its structure, that is to say at end injection points as shown on figures 13 or 14 of EP 2 396 804 B1. On figure 13 of EP 2 396 804 B1, the RF generator feeds the antenna at two opposing end points. On figure 14 of EP 2 396 804 B1, the RF generator feeds the antenna at two lower end injection points.

A quadratic (or bi-phased) feeding of the antenna is also possible. An example of such a configuration is shown on figure 9 of EP 2 396 804 B1. According to this embodiment the first leg and the last leg of the antenna are connected together at both ends by means of return lines each one containing a compensation capacitor. The value of the compensation capacitors is adjusted to compensate the inductance of the long conductors, necessary to cover the distance between the two extreme legs. The principle of the bi-phased feeding consists in exciting the antenna with two phase shifted signals injected at two distant injection points such as injection points.

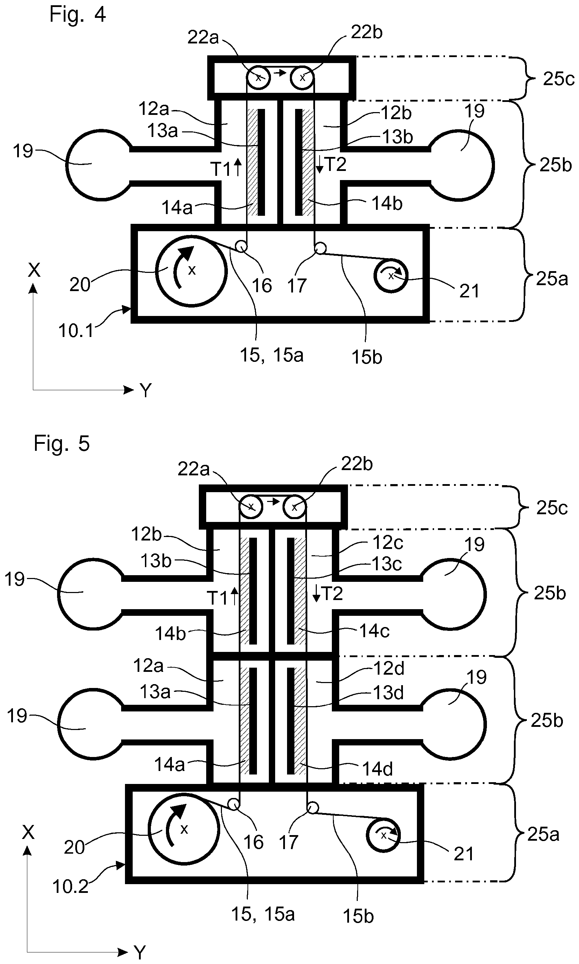

Figure 4, 5, 6a and 7a show in a very schematic manner different embodiments of the device 10.1, 10.2, 10.3, 10.4 (generally named: 10) according to the invention with a modular layout.

Basically, the layout of the device 10 is such that the device forms a first process section where the transporting path T1 of the web substrate is bottom up and that the device forms a second process section where the transporting path T2 of the web substrate is top down.

The device comprises a base module 25a with a unwind roller 20 and a rewind roller 21. The base module 25a also contains drives for driving the rollers 20, 21 (not shown). The base module 25a can also contain a treatment station, e.g. a pre-treatment station as e.g. shown in the embodiment according to figure 12.

The device 10 further comprises at least one treatment module 25b, 25'b, 25"b which is arranged atop the base module 25a. The at least one treatment module 25b, 25'b, 25"b contains a first and second treatment station 12a, 12b, each with a process chamber and a pumping system 19 to evacuate the process chamber. The pumping system 19 reduces and maintains the pressure in the region of e.g. a few Pa.

Of course, in each case a gas supply system is provided to feed the process chamber with a process gas. However, for reasons of simplicity the gas supply system is not shown in figure 4, 5, 6 and 7.

The treatment stations 12a, 12b are arranged side by side wherein the process direction, i.e. the transporting path T1 of the web substrate in the first treatment station 12a is bottom up and in the second treatment station 12b top down.

Each treatment station 12a, 12b further comprises a feed and a discharge passage opening for the web substrate. The passage openings form process interfaces between the modules.

On top of the modular device 10, i.e. above the at least one treatment module 25b, 25'b, 25"b, a deflection module 25c, i.e. a top module, is arranged. The deflection module 25c contains two deflection rollers 22a, 22b which deflect the web substrate 15 from a bottom up direction T1 into a top down direction T2.

In present case the deflection rollers 22a, 22b also serve as span rollers which forms together with the span rollers 16, 17 in the base module 25a a free span for the web substrate 15 in the treatment station 12a, 12b of the at least one treatment module 25b, 25'b, 25"b.

Each treatment station 12a, 12b of the at least one treatment module 25b, 25'b, 25"b contains at least one plasma treatment unit 13a, 13b with a flat antenna as it is e.g. shown in figure 1 to 3. The at least one plasma treatment unit 13a, 13b can e.g. comprise a plasma source assembly 80 as shown in figure 11.

The plane antenna 9 of the at least one plasma treatment unit 13a, 13b is vertically (X) aligned and runs parallel to the web substrate 15. Between the web substrate 15 and the antenna of the at least one plasma treatment unit 13a, 13b a vertical planer plasma zone 14a, 14b is formed for treating the surface of the web substrate facing the plasma zone 14a, 14b.

For treating the web substrate 15 the untreated web substrate 15a is continuously unwound from the unwind roller 20 and deflected by the deflection and span roller 16 into a bottom up direction. The web substrate enters the process chamber of the first treatment station 12a of the at least one treatment module 25b, 25'b, 25"b through a feed passage opening (not shown) and is transported through the first treatment station 12a. Thereby the web substrate 15 is transported in a bottom up direction through the plasma zone 14a and continuously treated by the plasma generated by the plasma treatment unit 13a of the first treatment station 12a.

The web substrate 15 leaves the process chamber of the first treatment station 12a through a discharge passage opening (not shown) and enters the deflection module 25c. In the deflection module 25c the web substrate 15 is deflected by the deflection and span rollers 22a, 22b from the bottom up direction into a top down direction T2.

The web substrate 15 during its transportation leaves the deflection module 25c and enters the process chamber of the second treatment station 12b by a feed passage opening (not shown) in the top down direction. Thereby the web substrate 15 is transported in a top down direction through the plasma zone 14b and continuously treated by the plasma generated by the plasma treatment unit 13b of the second treatment station 12b.

The web substrate 15 leaves the process chamber of the second treatment station 12b through a discharge passage opening (not shown) in the top down direction and enters the base module 25a. In the base module 25a the treated web substrate 15b is rewound by the rewind roller 21.

The devices 10.1, 10.3, 10.4 according to figures 4, 6a and 7a contain exactly one treatment module 25b, 25'b, 25"b which is arranged between the base module 25a and the deflection module 25c.

The first and second station 12a, 12b of the treatment module 25b together form two plasma zones for the same treatment, e.g. coating, of the same surface of the web substrate 15. Due to the double treatment of the web surface in a first treatment station 12a in a bottom up direction and in a second treatment station 12b in the top down direction the efficiency of the treatment process is increased.

The doubling of the treatment allows either the formation of thicker coatings at the same process speed or a coating of same quality at double speed in comparison with only one treatment step for the web surface.

In the embodiment according to figure 4 the process speed can be increased up to 400 m/min instead of 200 m/min with only one treatment station 12a. The line speed of a known capacitive plasma coupled magnetron device with one treatment drum is for comparison 100 m/min.

The device 10.2 according to figure 5 contains two identical treatment modules 25b as described above. The treatment modules 25b are arranged atop each other between the base module 25a and the deflection module 25c.

According to this arrangement the web substrate is transported in the first bottom up process section through to treatment stations 12a, 12b of the two treatment modules 25b and in the following second top down process section through another two treatment stations, 12c, 12d of the same two treatment modules 25b. Each of the four treatment stations 12a, 12b, 12c, 12d contains a plasma treatment unit 13a, 13b, 13c, 13d which forms a plasma zone 14a, 14b, 14c, 14d.

Accordingly, the treatment zone quadruples. I.e., the process speed can be increased up to 800 m/min instead of 400 m/min with only one treatment module 25b.

The treatment stations 12a, 12b of the devices according to figure 6a and 7a in each case contain a first and second plasma treatment unit 13a, 13'a; 13b, 13'b which are arranged opposite to each other so that the treatment path of the web substrates runs between a pair of plasma treatment units 13a, 13'a; 13b, 13'b. Between the web substrate 15 and the plasma treatment units 13a, 13'a; 13b, 13'b in each case a plasma zone 14a, 14'a; 14b, 14'b is formed, so that both sides of the web substrate 15 are treated simultaneously.

In the device according to figure 6a the web substrate 30c (see also figure 6b) in the first bottom up treatment station 12a is coated on a first web substrate side with a first coating 30b, e.g. a barrier coating, by a first plasma treatment unit 13a and on a second web substrate side with a second coating 30dby a second plasma treatment unit 13'a.

Subsequently the web substrate 30 in the second top down treatment station 12b is coated on the first web substrate side with a third coating 30a, e.g. a second barrier coating, by a first plasma treatment unit 13b and on the second web substrate side again with a further second coating 30d by a second plasma treatment unit 13'b.

As the different coating layers 30a, 30b are only coated with one plasma treatment unit 13a, 13b, the process speed is relatively low and is about 200 m/min. However, in return the web substrate is coated on both sides and with multi-layers within the mentioned process speed.

In the device according to figure 7a the web substrate 31b (see also figure 7b) in the first bottom up treatment station 12a is coated on a first web substrate side with a first coating 31a, e.g. a barrier coating, by a first plasma treatment unit 13a and on a second web substrate side with a second coating 31c by a second plasma treatment unit 13'a.

Subsequently the web substrate 31 in the second top down treatment station 12b is coated on the first web substrate side again with the same first coating 31a by a first plasma treatment unit 13b and on the second web substrate side again with the same second coating 31c by a second plasma treatment unit 13'b.

As the coating layers 31a, 31c on both sides of the web substrate are in each case coated on two plasma treatment units 13a, 13'a; 13b, 13'b the process speed is higher and amounts about 400 m/min.

Figure 8 shows schematically a treatment station 40 in more detail. The treatment station 40 defines a process chamber 50 with a feed passage opening 48a for the incoming web substrate 47a and with a discharge passage opening 48b for the outgoing treated web substrate 47c. The treatment station 40 further comprises a pumping system 42 for generating a low pressure in the process chamber 50.

Within the process chamber 50 a plasma treatment unit 45 with a plasma source assembly containing a plane antenna 9 is arranged. The plane antenna 9 is connected to an RF generator 41.

The plasma treatment unit 45 also contains a bias electrode arrangement with a bias electrode 44. The bias electrode 44 is arranged opposite to the plasma source assembly and extends over the whole area of the plane antenna 9. The bias electrode 44 runs parallel to the plane antenna 9. The bias electrode 44 is powered by an RF generator 52. A matching network 51 is provided which interconnects the RF generator 52 and the bias electrode 44.

The bias electrode aims the control of the ion bombardment on the coating during the coating growth process. In particular the coating density, the coating chemistry (e.g. hydrogen to carbon ratio and carbon atomic orbital hybridization, sp2/sp3) and the coating amorphisation can be controlled. As the ion bombardment is present during the full coating growth time, the obtained coating is isotropic.

According to a modification of the embodiment according to figure 8, the bias electrode 44a extends only over a part of the area of the plane antenna 9 as viewed in process direction. According to this modification the obtained coating exhibits anisotropic properties.

It is also possible to operate the treatment station 40 according to figure 8 without a bias electrode arrangement.

The web substrate 47 in the process chamber 50 is transported along a treatment path section between the plasma source assembly and the bias electrode 44. The length of the treatment path section within the plasma can e.g. be 0.2 to 1 m.

The treatment path section and accordingly the web substrate 47b in the treatment path section runs at a distance to the separation plane of the plasma source assembly so that the plasma zone 46 is formed between the web substrate 47b in the treatment path section and the separation plane. Thus, the plasma generated in the plasma zone 46 is confined between the web substrate 47b and the separation plane.

Within the process chamber 50 two deflection rollers 49a, 49b in the function of span members are provided which are spaced from each other and which form a free span for the web substrate 47. The treatment path section for the web substrate 47b lies within this free span.

Furthermore, a gas supply system 43 is provided which supplies a process gas into the plasma zone 46.

The figures 9 and 10 show different layouts of the web run within the process chamber of a plasma treatment unit, e.g. according to figure 8. Figures 9 and 10 also show a plasma treatment unit 55, 65 with a plasma source assembly connected to an RF generator 51, 61. Further, figures 9 and 10 show the incoming web substrate 57a, 67a and the outgoing treated web substrate 57c, 67d.

In figure 9 the deflection rollers 59a, 59b, which form the span members, are arranged such that the free span of the web substrate and accordingly the treatment path section is close to the separation plane of the plasma treatment unit 55 such that the plasma zone 56 is arranged on the side of the web substrate 57b in the treatment path section facing away from the plane antenna of the plasma treatment unit 55.

In figure 10 a first and second deflection roller 69a, 69b form a first and second span member and are arranged such that a first free span of the web substrate 67b and thus a first treatment path section are formed close to the separation plane of the plasma treatment unit 65. This, such that the plasma zone 66 is formed on the side of the web substrate 67b along the treatment path section facing away from the plane antenna of the plasma treatment unit 65.

The web substrate 67 is deflected on the second deflecting roller 69b such that the web substrate 67 runs in opposite direction towards a third deflection roller 69c which forms a third span member. The second and third deflection roller 69b, 69c are arranged such that a second free span of the web substrate 67c and thus a second treatment path section is formed which is spaced from the separation plane of the plasma treatment unit 65. This, such that the plasma zone 66 is arranged between the first and second free span of web substrate 67b, 67c, i.e. between the first and second treatment path section.

The treated web substrate 57c is deflected by a further deflection roller 69d before it leaves the process chamber (not shown).

The plasma source assembly according to figure 4, 5, 6a, 7a, 8, 9, 10, but also according to figure 12 can be designed according to figure 11. Figure 11 shows a plasma treatment unit with a plasma source assembly 80 and an RF generator 82. The plasma source assembly 80 comprises a plane antenna 9 as e.g. shown in figures 1, 2 and 3 which is connected to the RF generator 82.

The plane antenna 9 is embedded in a dielectric material 83. The plasma source assembly 80 further comprises a conductive bottom plate 85, e.g. of metal, which defines a lower termination of the plasma source assembly 80. The plasma source assembly 80 further contains a dielectric top plate 84, e.g. made of glass or ceramics, which defines an upper termination of the plasma source assembly 80. The dielectric top plate 84 is facing the plasma zone of the plasma treatment unit and forms the separation plane.

The dielectric material 83 is confined between the conductive bottom plate 85 and the dielectric top plate 84. The dielectric material 83 is further confined by a lateral frame 86 which laterally encloses the plasma source assembly 80.

The ladder-type, plane antenna 9 contains a plurality of parallel legs 1, 2 which are connected with shorter elements each containing a capacitor 5. The transporting direction P' of the web substrate can be parallel to the legs 1, 2. However, more uniform treatment results are achieved, when the transporting direction P of the web substrate runs perpendicular to the legs 1, 2.

Figure 12 shows a cross-section of a schematically outlined device 90 according to a further embodiment. The device comprises a base module 95a with an unwind roller 91 to unwind the untreated web substrate 94a and a rewind roller 93 to rewind the treated web substrate 94b.

The base module 95a further comprises a pre-treatment station 92a with a plasma treatment unit according to the invention which is arranged in a rear section of the base module 95a. Span rollers 98a, 98b define a free span which contains the treatment path section of the web substrate 94 in the treatment station 92a. The free span and accordingly the pre-treatment path section for the web substrate 94 and the plane antenna are vertically (X) aligned.

In the pre-treatment station 92a the web substrate 94 is prepared for a subsequent coating. A task of the preparation process is to increase the adhesion of the coating on the web substrate 94.

Furthermore, a treatment module 95b is arranged atop the base module 95a. The treatment module 95b contains two treatment stations 92b, 92c, each with a plasma treatment unit according to the invention for coating the web substrate 94. The treatment stations 92b, 92c are arranged side by side. The first treatment station 92b is arranged in a back section of the treatment module 95b and operated in a bottom up process direction P. The second treatment station 92c is arranged in a front section of the treatment module 95b and is operated in a top down process direction P.

Span rollers 98a, 98b in each case define a free span which contains the treatment path section of the web substrate 94 in the treatment stations 92b, 92c. The free spans and accordingly the treatment path sections for the web substrate 94 and the plane antenna are vertically (X) aligned.

On top of the device 90 and atop the treatment module 95b a top module 95c is arranged with driven deflection rollers 97a, 97b which deflect the web substrate 94 from a bottom up process direction into a top down process direction. The deflection rollers 97a, 97b also serve as cooling rollers.

The device 90 is operated by continuously unwinding an untreated web substrate 94a from the unwind roller 91 and continuously rewinding the treated web substrate 94b on the rewinding roller 93. During this process the web substrate 94 is transported in a back section of the device 90 via deflection rollers in a bottom up process direction through the pre-treatment station 92a. The web substrate 94 is pre-treated while passing through the pre-treatment station 92a.

Subsequently, the pre-treated web substrate 94 leaves the base module 95a and enters the treatment module 95b in the back section of the device 90, still in a bottom up process direction P.

The web substrate 94 is transported in the back section of the device 90 in a bottom up process direction through the first treatment station 92b of the treatment module 95b. The web substrate 94 is coated while passing through the first treatment station 92b.

Subsequently, the coated web substrate 94 leaves the treatment module 95b and enters the top module 95c. In the top module 95c the web substrate 94 is deflected from the bottom up process direction P into the top down process direction via deflecting rollers 97a, 97b.

Subsequently, the coated web substrate 94 leaves the top module 95c and enters again the treatment module 95b, this time in the top down process direction P and in a front section of the treatment module 95b or the device 90 respectively.

The web substrate 94 is transported in the front section of the device 90 in the top down process direction through the second treatment station 92c of the treatment module 95b. The web substrate 94 is coated while passing through the second treatment station 92c.

Subsequently, the treated web substrate 94b leaves again the treatment module 95b in the top down process direction and enters the base module 95a again.

In the base module 95a a quality control system 100 is arranged along the transporting path of the treated web substrate 94b. The quality control system 100 can comprise sensors which work on the principle of coating optical density measurement.

After the passing the quality control system 100 the treated web substrate 94b is further transported via deflection rollers to the rewind roller 93 and rewound. A layon roller 99 with constant distance assures a wrinkle free winding.

To ensure the required tension of the web substrate 94 along its process path, dancer rollers 96 can be provided.

Figure 13 shows an alternative design of a plasma treatment station 70a with a rotatable drum 72 and with a curved plasma source assembly 74a having a curved extensive antenna 73a. The curved shape of the extensive antenna 73a is adapted to the shape of the curved surface area of the rotatable drum 72. Accordingly, the cover plate of the plasma source assembly 74a facing the web substrate 71 is curved as well. The surface of the cover plate forms the separation surface.

The plasma source assembly 74a with its curved, extensive antenna 73a is arranged at a distance to the rotatable drum 72 so that a curved gap 75a is formed between the rotatable drum 72 and the plasma source assembly 74a. The plasma zone is formed in the space formed by the curved gap 75a.

Figure 14 shows a further alternative design of a plasma treatment station 70b with a rotatable drum 72 and with two plane plasma source assembly 74b having a plane antenna 73b. The cover plate facing the rotatable drum 72 towards the transporting path of the web substrate 71 is plane. The surface of the cover plate forms the separation surface.

The plasma source assembly 74b with its plane antenna 73b is arranged at a distance to the rotatable drum 72 so that a gap 75b is formed between the rotatable drum 72 and the plasma source assembly 74b. The plasma zone is formed in the space formed by the gap 75b.

In operation, the web substrate 71 according to figure 13 and 14, in the region of the formed plasma zone, rests on a curved circumferential treatment surface area of the drum 72 and is transported at the rotation speed of the rotating drum 72, while being coated.

Figure 15 shows a further layout of a plasma treatment station with a plasma treatment unit 115 and the web run within plasma treatment station.

The plasma treatment unit 115 contains a plasma source assembly with a plane antenna embedded in a dielectric material. The plasma source assembly is connected to an RF generator 112.

The plasma source assembly comprise on both opposites sides a dielectric cover plate which, in each case, forms a separation surface towards a web substrate treatment path. I.e. instead of a conductive base plate a second dielectric cover plate is provided.

As a consequence on both sides of the cover plate a plasma zone 116a, 116b is formed. The web substrate 117 now runs along a first treatment path parallel to the plane antenna at a distance to the first cover plate so that a first plasma zone 116a is formed between the web substrate 117, i.e. the first treatment path, and the first cover plate.

Subsequent to the first treatment path the web substrate 117 is deflected via a deflection roller 118 in an opposite transport direction at a distance and parallel to the first treatment path. The deflected web substrate 117 passes now the plane antenna, i.e. the plasma source assembly, on the opposite side and at distance to the second cover plate along a second treatment path. Between the web substrate 117, i.e. the second treatment path, and the second cover plate a second plasma zone 116b is formed. In the second plasma zone 116b a second treatment step is carried out on the surface of the web substrate 117 already treated in the first plasma zone 116a. The web substrates may be cooled or adjusted to a desired web temperature by the e.g. deflection roller 118 being designed as a cooling roller. However, providing a separate cooling roller is also possible.

Furthermore, a gas supply system, in particular gas injectors 114, is provided which supplies a process gas into the plasma zones 116a, 116b.

Accordingly, the plane antenna, i.e. the plasma source assembly, is arranged between a first and second parallel web substrate treatment path.

Figure 16 shows a further layout of a plasma treatment station with a plasma treatment unit 115 and the web run within plasma treatment station. The plasma treatment station is similar to the embodiment according to figure 15.

However, in this embodiment, two different substrate webs are treated along the first and second parallel web substrate treatment paths, in the plasma zones 116a and 116b, with the same plasma treatment unit 115 containing the same plasma source assembly arranged in between the two treatment paths as disclosed in figure 15. Thus, a first web substrate 119a is forwarded from a first unwinding storage reel 120a or prior treatment step, passing along the first treatment path, by the plasma source, and after plasma treatment forwarded to a next step or wound up onto a subsequent, first winding storage reel 120b, while simultaneously, a second web substrate 119b is forwarded from a second unwinding storage reel 121a or treatment step, passing along the second treatment path, by and on the other side of the plasma source, and after plasma treatment forwarded to a next step or wound up onto a second, subsequent, winding storage reel 121b.

The web substrates may be cooled or adjusted to a desired web temperature by cooling rollers at the inlets and outlets of the plasma treatment paths.

Furthermore, a gas supply system, in particular gas injectors 114, is provided which supplies a process gas into the plasma zones 116a, 116b.

## Claims

1. Device (10) for continuously treating a web substrate (15a) in a plasma enhanced process, the device (10) comprising at least one treatment station (12a, 12b) including a process chamber, wherein at least one plasma treatment unit (13a, 13b) is allocated to the at least one treatment station (12a, 12b) which is designed to form a plasma zone (14a, 14b) within the process chamber for treating a surface of the web substrate (15a), the device (10) further comprises a transporting system configured to continuously transport the web substrate (15a, 15b) through the at least one treatment station (12a, 12b), with an unwind roller (20) and a rewind roller (21), wherein the transporting system defines a transporting path of the web substrate (15a) through the process chamber, wherein the plasma treatment unit (13a, 13b) comprises at least one extensive antenna (9) and at least one radiofrequency (RF) generator (82); wherein the transportation system in the process chamber defines a treatment path section for the web substrate (15a), and wherein the treatment path section for the web substrate (15a) lies opposite to the at least one extensive antenna (9); **characterized in that** the at least one radiofrequency (RF) generator is configured to excite said at least one extensive antenna (9) to at least one of its resonant frequencies,
wherein the extensive antenna (9) comprises a plurality of interconnected elementary resonant meshes (M1, M2, M3), each mesh comprising at least two conductive legs (1, 2) and at least two capacitors (5, 6),
wherein the extensive antenna is arranged within the environment of the process chamber, wherein the plasma treatment unit (13a, 13b) comprises a separation surface (84) which physically separates the at least one extensive antenna (9) from the plasma zone (14a, 14b).

2. Device according to claim 1, characterised that the extensive antenna (9) is one of:
- a plane antenna;
- a curved antenna.

3. Device according to one of claims 1 or 2, **characterised in that** the plane antenna (9) and the treatment path section are vertically (X) aligned.

4. Device according to one of claims 1 to 3, **characterised in that** the transporting system contains a first and second span member (16, 22a; 22b, 17) which are spaced from each other, wherein between the span members (16, 22a; 22b, 17) a free span for the web substrate is defined which contains the treatment path section for the web substrate (15a).

5. Device according to one of claims 1 to 4, **characterised in that** the treatment path section of the web substrate (15a, 47a) runs at a distance from the separation surface (84) so that the plasma zone (14a, 14b; 46) is formed between the treatment path section of the web substrate (15a, 47a) and the separation surface (84).

6. Device according to one claims 1 to 4, **characterised in that** the treatment path section of the web substrate (57a) runs close to the separation surface (84) so that the plasma zone (56) is formed on the side of the web substrate (57b) which is facing away from the extensive antenna (81).

7. Device according to one claims 1 to 4, **characterised in that** the treatment path section of the web substrate (57a) forms the separation surface so that the plasma zone (56) is formed on the side of the web substrate (57b) which is facing away from the extensive antenna (81).

8. Device according to one of the previous claims, **characterised in that** the treatment station (40) contains a feed passage opening (48a) for feeding the web substrate (47a) into the process chamber (50) and a discharge passage opening (48b) for discharging the treated web substrate (47c) from the process chamber (50).

9. Device according to one of the previous claims, **characterised in that** the treatment station (40) contains a gas supply system (43) for supplying a process gas to the plasma zone (46) in the process chamber (50).

10. Device according to one of the previous claims, **characterised in that** the treatment station (40) contains a pumping system (42) for removing gaseous components from the process chamber (50).

11. Device according to one of the previous claims, **characterised in that** within a common process chamber at least two plasma treatment units or extensive antennas respectively are arranged, in each case forming a plasma zone for a surface treatment of the web substrate.

12. Device according to one of the previous claims, **characterised in that** the device contains a first treatment station (12a) with at least one plasma treatment unit (13a) and arranged in processing direction (P) subsequent to the first treatment station (12a) a second treatment station (12b) with at least one plasma treatment unit (13b), wherein the transporting system is designed such that the web substrate (15a) first can be transported through the first treatment station (12a) and subsequently through the second treatment station (12b) in a continuous manner.

13. Device according to claim 12, **characterised in that** in processing direction (P) between the plasma treatment unit (13a) of a preceding treatment station (12a) and the plasma treatment unit (13b) of a subsequent treatment station (12b) at least one deflection member (22a, 22b) is arranged, which deflects the web substrate (15a) such, that the transporting direction (T2) of the web substrate (15a) through the plasma zone (14b) of the plasma treatment unit (13b) of the subsequent treatment station (12b) is opposite or at an angle to the transporting direction (T1) of the web substrate (15a) through the plasma zone (14a) of the plasma treatment unit (13a) of the preceding treatment station (12a).

14. Device according to claim 6, **characterised in that** a first treatment path section of the web substrate (67b) runs close to the separation surface (84) or forms the separation surface and a second treatment path section (67c) runs at a distance to the separation surface (84) and the first treatment path section (67b), so that the plasma zone (66) is formed between the first and second treatment path section (67a, 67b) of the web substrate (67a).

15. Device according to one of the previous claims, **characterised in that** the device (10) has a modular layout and contains a base module (25a) with an unwind roller (20) and a rewind roller (21) and a treatment module (25b) with at least a treatment station (12a, 12b).

16. Device according to one of the previous claims, **characterised in that** the device (10) contains at least two process sections, wherein to each process section at least one plasma treatment unit (13a, 13b) for treating the web substrate (15) is allocated, and wherein the process direction (P) in one process section is bottom up and wherein the process direction (P) in the other process section is top down.

17. Device according to one of the claims 1-2, 5 and 6-11, characterised that the transporting system contains a rotatable drum (72), wherein the treatment path section of the web substrate (71) is curved and runs along a peripheral surface section of the rotatable drum (72) which defines a curved resting surface for the web substrate (71) in the process chamber.

18. Device according to one of the previous claims, **characterised in that** the treatment unit is designed to establish a plasma zone on both sides of the antenna, lying opposite to each other.

19. Method for continuously treating a web substrate (15a) in a plasma enhanced process with a device (10) according to one of the previous claims, containing the steps of:
- providing a web substrate (15a) with a first web end section which is placed on an unwind roller (20) and with a second web end section which is placed on a rewind roller (21) and with an intermediate web section;
- generating a plasma in the plasma zone (14a) of the at least one plasma treatment unit (13a);
- unwinding the web substrate (15a) from the unwind roller (20) and rewinding the treated web substrate (15b) by the rewind roller (21), thereby
- transporting an intermediate web section of the web substrate (15a) along the treatment path section in the at least one treatment station (12a) through the plasma zone of the plasma treatment unit (13a) and thereby plasma treating a surface of the web substrate (15a).

## Patentansprüche

1. Vorrichtung (10) zur kontinuierlichen Behandlung eines Bahnsubstrats (15a) in einem plasmagestützten Prozess, wobei die Vorrichtung (10) mindestens eine Behandlungsstation (12a, 12b) aufweist, die eine Prozesskammer umfasst, wobei der mindestens einen Behandlungsstation (12a, 12b) mindestens eine Plasmabehandlungseinheit (13a, 13b) zugewiesen ist, die so konzipiert ist, dass sie eine Plasmazone (14a, 14b) innerhalb der Prozesskammer zum Behandeln einer Oberfläche des Bahnsubstrats (15a) bildet, wobei die Vorrichtung (10) ferner ein Fördersystem aufweist, das zum kontinuierlichen Befördern des Bahnsubstrats (15a, 15b) durch die mindestens eine Behandlungsstation (12a, 12b) mit einer Abwickelrolle (20) und einer Aufwickelrolle (21) ausgelegt ist, wobei das Fördersystem einen Förderweg des Bahnsubstrats (15a) durch die Prozesskammer definiert, wobei die Plasmabehandlungseinheit (13a, 13b) mindestens eine extensive Antenne (9) und mindestens einen Hochfrequenz, HF,-Generator (82) aufweist; wobei das Fördersystem in der Prozesskammer einen Behandlungswegabschnitt für das Bahnsubstrat (15a) definiert, und wobei der Behandlungswegabschnitt für das Bahnsubstrat (15a) gegenüber der mindestens einen extensiven Antenne (9) liegt; **dadurch gekennzeichnet, dass** der mindestens eine Hochfrequenz, HF,-Generator so ausgelegt ist, dass er die mindestens eine Antenne (9) auf mindestens eine ihrer Resonanzfrequenzen erregt,
wobei die extensive Antenne (9) eine Mehrzahl von miteinander verbundenen elementaren Resonanzgittern (M1, M2, M3) aufweist, wobei jedes Gitter mindestens zwei leitende Schenkel (1, 2) und mindestens zwei Kondensatoren (5, 6) aufweist,
wobei die extensive Antenne innerhalb der Umgebung der Prozesskammer angeordnet ist,
wobei die Plasmabehandlungseinheit (13a, 13b) eine Trennfläche (84) aufweist, welche die mindestens eine extensive Antenne (9) physisch von der Plasmazone (14a, 14b) trennt.

2. Vorrichtung nach Anspruch 1, **dadurch gekennzeichnet, dass** die extensive Antenne (9) eine ist von:
- einer flachen Antenne;
- einer gekrümmten Antenne.

3. Vorrichtung nach einem der Ansprüche 1 oder 2, **dadurch gekennzeichnet, dass** die flache Antenne (9) und der Behandlungswegabschnitt vertikal (X) ausgerichtet sind.

4. Vorrichtung nach einem der Ansprüche 1 bis 3, **dadurch gekennzeichnet, dass** das Fördersystem ein erstes und ein zweites Abstandselement (16, 22a; 22b, 17) aufweist, die voneinander beabstandet sind, wobei zwischen den Abstandselementen (16, 22a; 22b, 17) ein freier Bereich für das Bahnsubstrat definiert ist, der den Behandlungswegabschnitt für das Bahnsubstrat (15a) enthält.

5. Vorrichtung nach einem der Ansprüche 1 bis 4, **dadurch gekennzeichnet, dass** der Behandlungswegabschnitt des Bahnsubstrats (15a, 47a) in einer Entfernung von der Trennfläche (84) verläuft, so dass die Plasmazone (14a, 14b; 46) zwischen dem Behandlungswegabschnitt des Bahnsubstrats (15a, 47a) und der Trennfläche (84) ausgebildet ist.

6. Vorrichtung nach einem der Ansprüche 1 bis 4, **dadurch gekennzeichnet, dass** der Behandlungswegabschnitt des Bahnsubstrats (57a) nahe der Trennfläche (84) verläuft, so dass die Plasmazone (56) auf der Seite des Bahnsubstrats (57b) ausgebildet ist, die von der extensiven Antenne (81) abgewandt ist.

7. Vorrichtung nach einem Ansprüche 1 bis 4, **dadurch gekennzeichnet, dass** der Behandlungswegabschnitt des Bahnsubstrats (57a) die Trennfläche bildet, so dass die Plasmazone (56) auf der Seite des Bahnsubstrats (57b) ausgebildet ist, die von der extensiven Antenne (81) abgewandt ist.

8. Vorrichtung nach einem der vorhergehenden Ansprüche, **dadurch gekennzeichnet, dass** die Behandlungsstation (40) eine Zuführpassagenöffnung (48a) zum Zuführen des Bahnsubstrats (47a) in die Prozesskammer (50) und eine Abführpassagenöffnung (48b) zum Abführen des behandelten Bahnsubstrats (47c) aus der Prozesskammer (50) enthält.

9. Vorrichtung nach einem der vorhergehenden Ansprüche, **dadurch gekennzeichnet, dass** die Behandlungsstation (40) ein Gasversorgungssystem (43) zum Versorgen der Plasmazone (46) in der Prozesskammer (50) mit Prozessgas enthält.

10. Vorrichtung nach einem der vorhergehenden Ansprüche, **dadurch gekennzeichnet, dass** die Behandlungsstation (40) ein Pumpsystem (42) zum Entfernen von gasförmigen Komponenten aus der Prozesskammer (50) enthält.

11. Vorrichtung nach einem der vorhergehenden Ansprüche, **dadurch gekennzeichnet, dass** innerhalb einer gemeinsamen Prozesskammer mindestens zwei Plasmabehandlungseinheiten bzw. extensive Antennen angeordnet sind, die in jedem Fall eine Plasmazone für eine Oberflächenbehandlung des Bahnsubstrats bilden.

12. Vorrichtung nach einem der vorhergehenden Ansprüche, **dadurch gekennzeichnet, dass** die Vorrichtung eine erste Behandlungsstation (12a) mit mindestens einer Plasmabehandlungseinheit (13a) und eine zweite Behandlungsstation (12b), die in Verarbeitungsrichtung (P) nach der ersten Behandlungsstation (12a) angeordnet ist, mit mindestens einer Plasmabehandlungseinheit (13b) enthält, wobei das Fördersystem derart konzipiert ist, dass das Bahnsubstrat (15a) auf eine kontinuierliche Weise durch die erste Behandlungsstation (12a) und anschließend durch die zweite Behandlungsstation (12b) befördert werden kann.

13. Vorrichtung nach Anspruch 12, **dadurch gekennzeichnet, dass** in Verarbeitungsrichtung (P) zwischen der Plasmabehandlungseinheit (13a) einer vorhergehenden Behandlungsstation (12a) und der Plasmabehandlungseinheit (13b) einer nachfolgenden Behandlungsstation (12b) mindestens ein Umlenkelement (22a, 22b) angeordnet ist, welches das Bahnsubstrat (15a) derart umlenkt, dass die Förderrichtung (T2) des Bahnsubstrats (15a) durch die Plasmazone (14b) der Plasmabehandlungseinheit (13b) der nachfolgenden Behandlungsstation (12b) entgegengesetzt zur oder in einem Winkel auf die Förderrichtung (T1) des Bahnsubstrats (15a) durch die Plasmazone (14a) der Plasmabehandlungseinheit (13a) der vorhergehenden Behandlungsstation (12a) ist.

14. Vorrichtung nach Anspruch 6, **dadurch gekennzeichnet, dass** ein erster Behandlungswegabschnitt des Bahnsubstrats (67b) nahe der Trennfläche (84) verläuft oder die Trennfläche bildet, und ein zweiter Behandlungswegabschnitt (67c) in einer Entfernung von der Trennfläche (84) und dem ersten Behandlungswegabschnitt (67b) verläuft, so dass die Plasmazone (66) zwischen dem ersten und dem zweiten Behandlungswegabschnitt (67a, 67b) des Bahnsubstrats (67a) ausgebildet ist.

15. Vorrichtung nach einem der vorhergehenden Ansprüche, **dadurch gekennzeichnet, dass** die Vorrichtung (10) einen modularen Aufbau aufweist und ein Basismodul (25a) mit einer Abwickelrolle (20) und einer Aufwickelrolle (21) und ein Behandlungsmodul (25b) mit mindestens einer Behandlungsstation (12a, 12b) enthält.

16. Vorrichtung nach einem der vorhergehenden Ansprüche, **dadurch gekennzeichnet, dass** die Vorrichtung (10) mindestens zwei Prozessabschnitte enthält, wobei jedem Prozessabschnitt mindestens eine Plasmabehandlungseinheit (13a, 13b) zum Behandeln des Bahnsubstrats (15) zugewiesen ist, und wobei die Prozessrichtung (P) in einem Prozessabschnitt von unten nach oben ist, und wobei die Prozessrichtung (P) im anderen Prozessabschnitt von oben nach unten ist.

17. Vorrichtung nach einem der Ansprüche 1 bis 2, 5 und 6 bis 11, **dadurch gekennzeichnet, dass** das Fördersystem eine drehbare Walze (72) enthält, wobei der Behandlungswegabschnitt des Bahnsubstrats (71) gekrümmt ist und entlang eines Umfangsflächenabschnitts der drehbaren Walze (72) verläuft, der eine gekrümmte Auflagefläche für das Bahnsubstrat (71) in der Prozesskammer definiert.

18. Vorrichtung nach einem der vorhergehenden Ansprüche, **dadurch gekennzeichnet, dass** die Behandlungseinheit so konzipiert ist, dass sie eine Plasmazone auf beiden Seiten der Antenne etabliert, die einander gegenüberliegen.

19. Verfahren zur kontinuierlichen Behandlung eines Bahnsubstrats (15a) in einem plasmagestützten Prozess mit einer Vorrichtung (10) nach einem der vorhergehenden Ansprüche, das die folgenden Schritte enthält:
- Bereitstellen eines Bahnsubstrats (15a) mit einem ersten Bahnendabschnitt, der auf einer Abwickelrolle (20) angeordnet wird, und mit einem zweiten Bahnendabschnitt, der auf einer Aufwickelrolle (21) angeordnet wird, und mit einem dazwischenliegenden Bahnabschnitt;
- Erzeugen eines Plasmas in der Plasmazone (14a) der mindestens einen Plasmabehandlungseinheit (13a);
- Abwickeln des Bahnsubstrats (15a) von der Abwickelrolle (20) und Wiederaufwickeln des behandelten Bahnsubstrats (15b) durch die Aufwickelrolle (21), dadurch
- Befördern eines dazwischenliegenden Bahnabschnitts des Bahnsubstrats (15a) entlang des Behandlungswegabschnitt in der mindestens einen Behandlungsstation (12a) durch die Plasmazone der Plasmabehandlungseinheit (13a) und dadurch Plasmabehandeln einer Oberfläche des Bahnsubstrats (15a).

## Revendications

1. Dispositif (10) permettant de traiter en continu un substrat en bande (15a) dans un traitement assisté par plasma, le dispositif (10) comprenant au moins un poste de traitement (12a, 12b) comportant une chambre de traitement, dans lequel au moins une unité de traitement par plasma (13a, 13b) est attribuée à au moins un poste de traitement (12a, 12b) qui est conçu pour former une zone de plasma (14a, 14b) à l'intérieur de la chambre de traitement pour traiter une surface du substrat en bande (15a), le dispositif (10) comprenant en outre un système de transport conçu pour transporter en continu le substrat en bande (15a, 15b) à travers l'au moins un poste de traitement (12a, 12b), avec un rouleau dérouleur (20) et un rouleau enrouleur (21), dans lequel le système de transport définit un trajet de transport du substrat en bande (15a) à travers la chambre de traitement,
dans lequel l'unité de traitement par plasma (13a, 13b) comprend au moins une antenne étendue (9)
et au moins un générateur de radiofréquence (RF) (82) ; dans lequel le système de transport dans la chambre de traitement définit une section de trajet de traitement pour le substrat en bande (15a), et dans lequel la section de trajet de traitement pour le substrat en bande (15a) se trouve en regard de l'au moins une antenne étendue (9) ; **caractérisé en ce que** l'au moins un générateur de radiofréquence (RF) est configuré pour exciter ladite au moins une antenne étendue (9) à au moins une de ses fréquences de résonance,
dans lequel l'antenne étendue (9) comprend une pluralité de mailles résonantes élémentaires interconnectées (M1, M2, M3), chaque maille comprenant au moins deux jambes conductrices (1, 2) et au moins deux condensateurs (5, 6),
dans lequel l'antenne étendue est agencée dans l'environnement de la chambre de traitement,
dans lequel l'unité de traitement par plasma (13a, 13b) comprend une surface de séparation (84) qui sépare physiquement l'au moins une antenne étendue (9) de la zone de plasma (14a, 14b).

2. Dispositif selon la revendication 1, **caractérisé en ce que** l'antenne étendue (9) est une parmi :
- une antenne plane ;
- une antenne courbe.

3. Dispositif selon l'une des revendications 1 et 2, **caractérisé en ce que** l'antenne plane (9) et la section de trajet de traitement sont alignées verticalement (X).

4. Dispositif selon l'une des revendications 1 à 3, **caractérisé en ce que** le système de transport contient des premier et second éléments d'écartement (16, 22a ; 22b, 17) qui sont espacés l'un de l'autre, dans lequel, entre les éléments d'écartement (16, 22a ; 22b, 17), un écartement libre pour le substrat en bande est défini et contient la section de trajet de traitement pour le substrat en bande (15a).

5. Dispositif selon l'une des revendications 1 à 4, **caractérisé en ce que** la section de trajet de traitement du substrat en bande (15a, 47a) défile à une certaine distance de la surface de séparation (84) de sorte que la zone de plasma (14a, 14b ; 46) soit formée entre la section de trajet de traitement du substrat en bande (15a, 47a) et la surface de séparation (84).

6. Dispositif selon l'une des revendications 1 à 4, **caractérisé en ce que** la section de trajet de traitement du substrat en bande (57a) défile près de la surface de séparation (84) de sorte que la zone de plasma (56) soit formée sur le côté du substrat en bande (57b) qui est à l'opposé de l'antenne étendue (81).

7. Dispositif selon l'une des revendications 1 à 4, **caractérisé en ce que** la section de trajet de traitement du substrat en bande (57a) forme la surface de séparation de sorte que la zone de plasma (56) soit formée sur le côté du substrat en bande (57b) qui est à l'opposé de l'antenne étendue (81).

8. Dispositif selon l'une des revendications précédentes, **caractérisé en ce que** le poste de traitement (40) contient une ouverture (48a) de passage d'alimentation pour introduire le substrat en bande (47a) dans la chambre de traitement (50) et une ouverture (48b) de passage d'évacuation pour faire sortir le substrat en bande traité (47c) de la chambre de traitement (50).

9. Dispositif selon l'une des revendications précédentes, **caractérisé en ce que** le poste de traitement (40) contient un système d'alimentation en gaz (43) pour introduire un gaz de traitement dans la zone de plasma (46) dans la chambre de traitement (50).

10. Dispositif selon l'une des revendications précédentes, **caractérisé en ce que** le poste de traitement (40) contient un système de pompage (42) pour éliminer les constituants gazeux de la chambre de traitement (50).

11. Dispositif selon l'une des revendications précédentes, **caractérisé en ce que**, à l'intérieur d'une chambre de traitement commune, au moins deux unités de traitement par plasma ou antennes étendues sont respectivement agencées, dans chaque cas formant une zone de plasma pour un traitement de surface du substrat en bande.

12. Dispositif selon l'une des revendications précédentes, **caractérisé en ce que** le dispositif contient un premier poste de traitement (12a) assorti d'au moins une unité de traitement par plasma (13a) et, disposé dans une direction de traitement (P) à la suite du premier poste de traitement (12a), un second poste de traitement (12b) assorti d'au moins une unité de traitement par plasma (13b), dans lequel le système de transport est conçu de façon que le substrat en bande (15a) puisse d'abord être transporté à travers le premier poste de traitement (12a) et, par la suite, à travers le second poste de traitement (12b) de manière continue.

13. Dispositif selon la revendication 12, **caractérisé en ce que**, dans la direction de traitement (P) entre l'unité de traitement par plasma (13a) d'un poste de traitement (12a) précédent et l'unité de traitement par plasma (13b) d'un poste de traitement (12b) suivant, au moins un élément de déviation (22a, 22b) est agencé, qui dévie le substrat en bande (15a) de façon que la direction de transport (T2) du substrat en bande (15a) à travers la zone de plasma (14b) de l'unité de traitement par plasma (13b) du poste de traitement (12b) suivant soit en regard de la direction de transport (T1) du substrat en bande (15a) ou forme un angle par rapport à celle-ci à travers la zone de plasma (14a) de l'unité de traitement par plasma (13a) du poste de traitement (12a) précédent.

14. Dispositif selon la revendication 6, **caractérisé en ce qu'**une première section de trajet de traitement du substrat en bande (67b) défile près de la surface de séparation (84) ou forme la surface de séparation et qu'une seconde section de trajet de traitement (67c) défile à une certaine distance de la surface de séparation (84) et de la première section de trajet de traitement (67b), de façon que la zone de plasma (66) soit formée entre les première et seconde sections de trajet de traitement (67a, 67b) du substrat en bande (67a).

15. Dispositif selon l'une des revendications précédentes, **caractérisé en ce que** le dispositif (10) présente une dispositif modulaire et contient un module de base (25a) équipé d'un rouleau dérouleur (20) et d'un rouleau enrouleur (21) et un module de traitement (25b) équipé d'au moins un poste de traitement (12a, 12b).

16. Dispositif selon l'une des revendications précédentes, **caractérisé en ce que** le dispositif (10) contient au moins deux sections de traitement, dans lequel à chaque section de traitement est attribuée au moins une unité de traitement par plasma (13a, 13b) pour traiter le substrat en bande (15), et dans lequel la direction de traitement (P) dans une section de traitement est de bas en haut, et dans lequel la direction de traitement (P) dans l'autre section de traitement est de haut en bas.

17. Dispositif selon l'une des revendications 1 à 2, 5 et 6 à 11, **caractérisé en ce que** le système de transport contient un tambour rotatif (72), dans lequel la section de trajet de traitement du substrat en bande (71) est courbée et défile le long d'une section de surface périphérique du tambour rotatif (72) qui définit une surface de repos courbée pour le substrat en bande (71) dans la chambre de traitement.

18. Dispositif selon l'une des revendications précédentes, **caractérisé en ce que** l'unité de traitement est conçue pour établir une zone de plasma des deux côtés de l'antenne, se trouvant en regard l'une de l'autre.

19. Procédé permettant de traiter en continu un substrat en bande (15a) dans un traitement assisté par plasma avec un dispositif (10) selon l'une des revendications précédentes, contenant les étapes consistant à :
- fournir un substrat en bande (15a) doté d'une première section extrémité de bande qui est placée sur un rouleau dérouleur (20) et d'une seconde section extrémité de bande qui est placée sur un rouleau enrouleur (21) et d'une section de bande intermédiaire ;
- générer un plasma dans la zone de plasma (14a) de l'au moins une unité de traitement par plasma (13a) ;
- dérouler le substrat en bande (15a) depuis le rouleau dérouleur (20) et enrouler le substrat en bande (15b) traité par le rouleau enrouleur (21), ce qui permet de
- transporter une section de bande intermédiaire du substrat en bande (15a) le long de la section de trajet de traitement dans l'au moins un poste de traitement (12a) à travers la zone de plasma de l'unité de traitement par plasma (13a) et de ce fait traiter par plasma une surface du substrat en bande (15a).
